# EUROPEAN PATENT SPECIFICATION

(11) **EP 3 659 218 B1**
(45) Date of publication and mention of the grant of the patent: **19.07.2023**
(21) Application number: 18837887.1
(22) Date of filing: 27.07.2018
(51) Int. Cl.: H01M 50/209, H01M 50/284, H01M 50/296, H01M 50/569, H01M 10/42, H01M 10/48, H01M 10/06, H01M 50/15, G01R 1/04, G01R 31/371, G01R 31/382, H02J 7/00, H02J 7/35

(54) **WIRELESS ENABLED MONOBLOC**
DRAHTLOSER AKTIVIERTER MONOBLOC
MONOBLOC ACTIVÉ SANS FIL

(30) Priority: 28.07.2017 US 201762538622 P; 18.12.2017 US 201762599958 P; 19.04.2018 US 201862660157 P; 19.04.2018 US 201862659929 P; 01.06.2018 US 201862679648 P; 26.07.2018 US 201816046727; 26.07.2018 US 201816046883; 26.07.2018 US 201816046671; 26.07.2018 US 201816046709; 26.07.2018 US 201816046747; 26.07.2018 US 201816046855; 26.07.2018 US 201816046774; 26.07.2018 US 201816046687; 26.07.2018 US 201816046811; 26.07.2018 US 201816046792; 26.07.2018 US 201816046737; 26.07.2018 US 201816046773; 26.07.2018 US 201816046791; 26.07.2018 US 201816046777
(43) Date of publication of application: 03.06.2020
(73) Proprietor: Northstar Battery Company, LLC, Springfield, MO 65803 (US)
(72) Inventor: BURNS, Steve, Springfield Missouri 65803 (US); SMITH, Doug, Springfield Missouri 65803 (US); HARRILL, Austin, Springfield Missouri 65803 (US); HOOKE, John, Springfield Missouri 65803 (US); KROHN, Ulf, Springfield Missouri 65803 (US); LINDKVIST, Christer, Springfield Missouri 65803 (US); FLEMING, Frank, Springfield Missouri 65803 (US); KARNER, Don, Springfield Missouri 65803 (US)
(74) Representative: Abel & Imray LLP
(86) International application number: PCT/US2018/044232
(87) International publication number: WO 2019/023672

(56) References cited:
- US-A- 5 344 725
- US-A1- 2005 042 936
- US-A1- 2005 089 750
- US-A1- 2010 297 478
- US-A1- 2012 094 150
- US-B1- 6 635 380

## Description

### FIELD OF THE INVENTION

The present disclosure relates generally to monitoring of energy storage devices, and in particular, to monitoring of energy storage devices having monitoring components disposed within the energy storage devices.

### BACKGROUND OF INVENTION

Lead-acid energy storage devices are prevalent and have been used in a variety of applications for well over 100 years. In some instances, these energy storage devices have been monitored to assess a condition of the energy storage device. Nevertheless, these prior art monitoring techniques typically are complex enough and sufficiently costly as to limit their use, and to limit the amount of data that is obtained, particularly in low-value, remote applications. For example, there is generally insufficient data about the history of a specific energy storage device over the life of its use. Moreover, in small numbers, some energy storage devices are coupled with sensors to collect data about the energy storage system, but this is not typical of large numbers of devices and/or in geographically dispersed systems. Often the limited data obtained via known monitoring systems/schemes is insufficient to support analysis, actions, notifications and determinations that may otherwise be desirable. Similarly, limitations exist for non-lead-acid energy storage devices. In particular, these batteries, due to their high energy and power, have entered various new mobile applications that have not been suitable for conventional monitoring systems. Accordingly, new devices, systems and methods for monitoring energy storage devices (batteries in particular) remain desirable and provide new opportunities in managing one or more energy storage devices, including those in service at diverse and/or remote geographic locations.

US 2010/297478 A1 describes a lead acid battery having a liquid surface sensor installed to a liquid surface sensor installation portion on a top face of a container lid, an electronic circuit board contained in a recessed portion on the top face of the container lid, terminal connecting conductors connecting the electronic circuit board to terminals, and a liquid surface sensor connecting conductor connecting the liquid surface sensor to the electronic circuit board, preventing from catching on an object on the top face of the container lid by insert molding the terminal connecting conductors and the liquid surface sensor connecting conductor in the container lid, preventing the terminal connecting conductors and the liquid surface sensor connecting conductor from being corroded by an electrolyte solution even if the electrolyte solution is spotted on the top face, and improving the outer appearance.

### SUMMARY OF INVENTION

An exemplary embodiment is directed to a top case component of a lead-acid monobloc case, the top case component comprising:
a top exterior surface of the monobloc case;
a top interior surface of the monobloc case;
a top sealing surface configured to be sealingly bonded with a bottom sealing surface of a primary case component of the monobloc case, wherein the primary case component further comprises integral sides and bottom and the bottom sealing surface corresponds to the uppermost surfaces of the integral sides;
a positive terminal opening configured for a positive terminal pole of a monobloc to protrude through; and
a negative terminal opening configured for a negative terminal pole of the monobloc to protrude through;
wherein the top exterior surface of the monobloc case comprises:
a pocket configured to house a battery monitor circuit, wherein at least a bottommost surface of the pocket is below the top sealing surface such that when the top case component is bonded to the primary case component the pocket extends into an interior of the monobloc case past the sealed interface of the top case component and the primary case component; and
at least one pathway configured to house electrically conducting connections that place the battery monitor circuit in electrical connection with the positive and negative terminal poles of the monobloc.

Another exemplary embodiment is directed to a top case component wherein the pocket is configured in the top case component so that the pocket will be proximate to an intercell connector between electrochemical cell packs of the monobloc.

In another exemplary embodiment, the battery monitor circuit is on a circuit board, and wherein the pocket is configured to house the circuit board at an orientation selected from the group consisting of substantially horizontal, substantially vertical, or between substantially vertical and substantially horizontal.

In another exemplary embodiment, the pocket comprises one or more structures configured to secure the circuit board within the pocket.

In another exemplary embodiment, the top case component further comprises the battery monitor circuit housed in the pocket.

In another exemplary embodiment, the top case component further comprises the electrically conducting connections housed in the at least one pathway.

In another exemplary embodiment, the battery monitor circuit comprises:
a voltage sensor configured to be electrically connected to the positive and negative terminal poles of the monobloc for receiving power from the monobloc and for monitoring a voltage between the positive and negative terminal poles of the monobloc;
a temperature sensor for monitoring a temperature at a location within the lead-acid monobloc that is below the top sealing surface of the lead-acid monobloc;
a processor for receiving a monitored voltage signal from the voltage sensor, for receiving a monitored temperature signal from the temperature sensor, for processing the monitored voltage signal and the monitored temperature signal, and for generating voltage data and temperature data based on the monitored voltage signal and the monitored temperature signal;
a memory for storing the voltage data and the temperature data, wherein the voltage data represents the voltage between the positive and negative terminal poles of the monobloc, and wherein the temperature data represents a temperature of the monobloc;
an antenna; and
a transceiver for wirelessly communicating the voltage data and the temperature data to a remote device via the antenna.

In another exemplary embodiment, the battery monitor circuit further comprises further comprises a geo-location device for identifying a location of the top case component, and representing the location of the top case component with location data.

In another exemplary embodiment, the top case component further comprises a composition for securing and protecting the battery monitor circuit housed in the pocket and the electrically conducting connections housed in the at least one pathway.

In another exemplary embodiment, the aforementioned composition is selected from the group consisting of potting material, adhesive, and combinations thereof.

In another exemplary embodiment, the processor is configured to analyze the voltage data and the temperature data and generate information derived from the voltage data and the temperature data.

In another exemplary embodiment, the memory contains operating history of the monobloc in a battery operating history matrix, and wherein the battery operating history matrix comprises:
a plurality of columns, each column representing a voltage range of the monobloc; and
a plurality of rows, each row representing a temperature range of the monobloc, wherein a numerical value in a cell of the battery operating history matrix represents a cumulative amount of time that the monobloc has been in a particular state corresponding to the voltage range and the temperature range for that cell.

In another exemplary embodiment, during operation of the battery monitor circuit, the memory stores information corresponding to the cumulative amount of time that the monobloc is in each of the plurality of states represented by the battery operating history matrix over a time period for which the battery monitor circuit is electrically connected to the monobloc, thereby characterizing the entire connected life of the monobloc, without increasing the storage space in the memory occupied by the battery operating history matrix.

In another exemplary embodiment, the remote device further comprises a remote display system, remote from the monobloc, for displaying a location history and a battery operation history of the monobloc.

In another exemplary embodiment, the invention is directed to a lead-acid monobloc case, the case comprising the primary case component and any of the foregoing embodiments of the top case component, wherein the primary case component and the top case component, when assembled, define at least one cell within the monobloc case.

In another exemplary embodiment, the primary case has a draft directed toward the bottom such the integral sides slope inward from their uppermost surfaces to the bottom.

In another exemplary embodiment, the primary case component further comprises at least one integral interior wall such that the primary case component and the top case component, when assembled, define a number of cells in the monobloc case.

Another embodiment of the invention is directed to a wireless enabled lead-acid monobloc comprising: any of the foregoing embodiments of the lead-acid monobloc; an electrochemical cell pack in each cell; an intercell connector between each electrochemical cell pack; the positive and negative terminal poles in electrical connection with the electrochemical cell pack(s); and the monobloc parameter monitoring device and the wireless communications device are in electrical connection with the positive and negative terminal poles.

Another embodiment of the invention is directed to a battery pack comprising: at least one string of wireless enabled monoblocs, wherein each string comprises a plurality of the wireless enabled lead-acid monoblocs electrically connected in series or parallel; and battery pack positive and negative terminals electrically connected to the string or strings, wherein the strings are electrically connected in parallel.

The contents of this section are intended to be a simplified introduction to the disclosure and are not intended to limit the scope of any claim.

### BRIEF DESCRIPTION OF THE DRAWINGS

FIG. 1 illustrates a monobloc having a battery monitor circuit disposed therein, in accordance with various embodiments.
FIG. 2 illustrates a battery pack comprising multiple monoblocs, with each monobloc having a battery monitor circuit disposed therein, in accordance with various embodiments.
FIG. 3 illustrates a method of monitoring a battery in accordance with various embodiments.
FIG. 4A illustrates a battery monitoring system, in accordance with various embodiments.
FIG. 4B illustrates a battery operating history matrix having columns representing a range of voltage measurements, and rows representing a range of temperature measurements, in accordance with various embodiments.
FIG. 4C illustrates a battery having a battery monitor circuit disposed therein, the battery coupled to a load and/or to a power supply, and in communicative connection with various local and/or remote electronic systems, in accordance with various embodiments.
FIG. 6 illustrates an exemplary wireless enabled monobloc (WEM), in accordance with various embodiments.

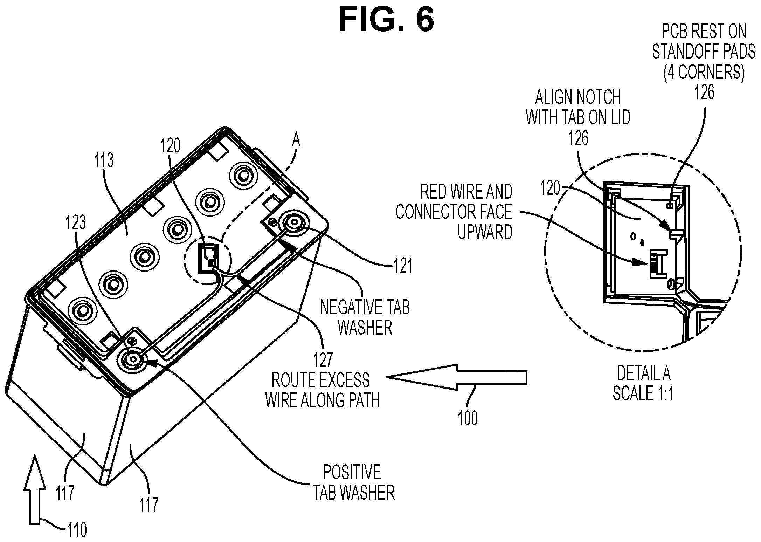

FIG. 6 illustrates an exemplary wireless enabled monobloc (WEM), in accordance with various embodiments.

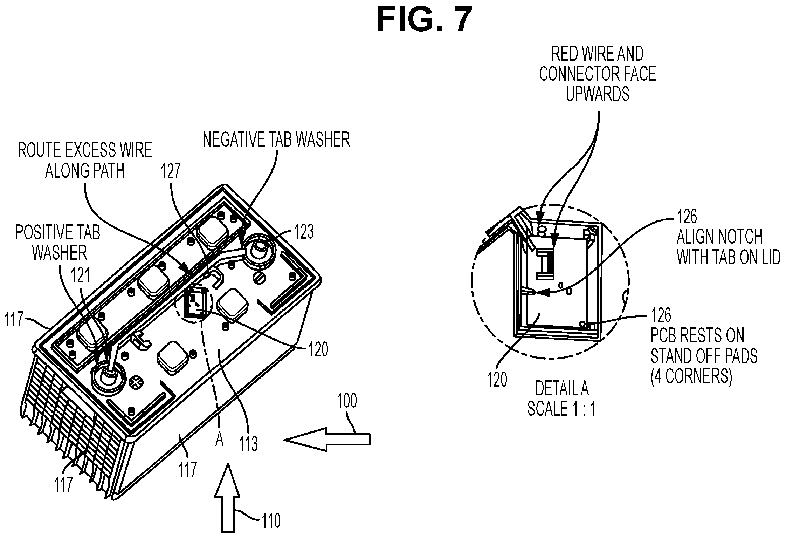

FIG. 7 illustrates an exemplary wireless enabled monobloc (WEM), in accordance with various embodiments.

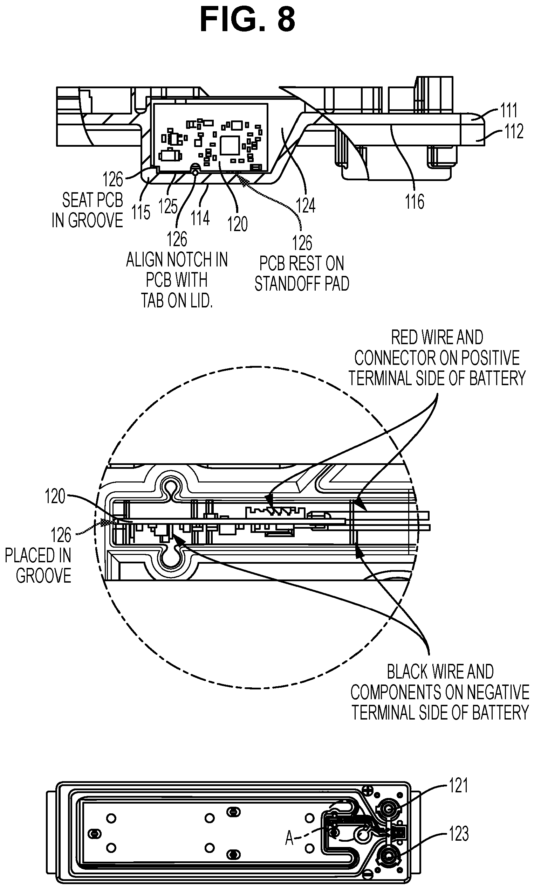

FIG. 8 illustrates an exemplary wireless enabled monobloc (WEM), in accordance with various embodiments.

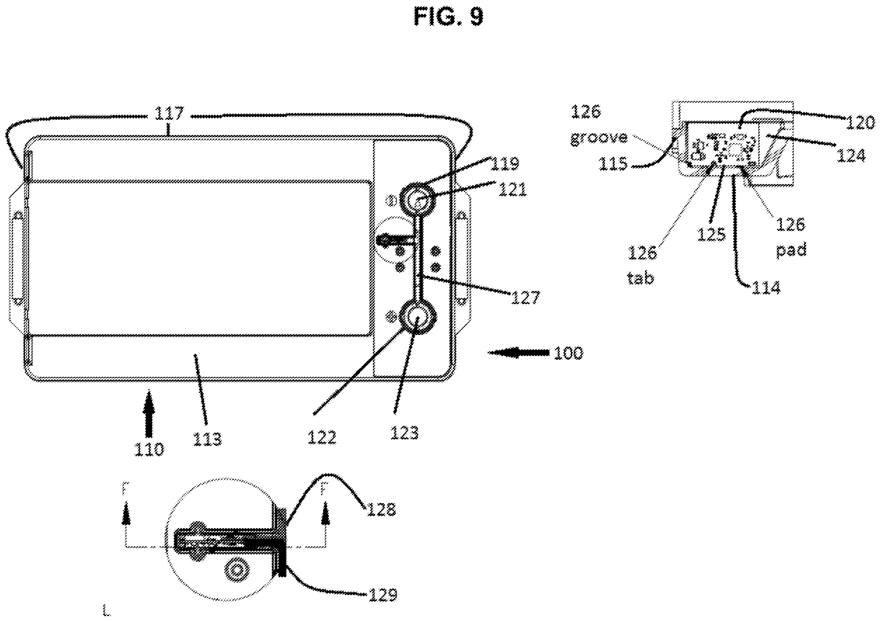

FIG. 9 illustrates an exemplary wireless enabled monobloc (WEM), in accordance with various embodiments.

### DETAILED DESCRIPTION OF INVENTION

The detailed description shows embodiments by way of illustration, including the best mode. The steps recited in any of the method descriptions may be executed in any suitable order and are not limited to the order presented.

Moreover, for the sake of brevity, certain sub-components of individual components and other aspects of the system may not be described in detail herein. It should be noted that many alternative or additional functional relationships or physical couplings may be present in a practical system, for example a battery monitoring system. Such functional blocks may be realized by any number of suitable components configured to perform specified functions.

Principles of the present disclosure improve the operation of a battery, for example by eliminating monitoring components such as a current sensor that can drain a battery of charge prematurely. Further, a battery monitoring circuit may be embedded within the battery at the time of manufacture, such that it is capable of monitoring the battery and storing / transmitting associated data from the first day of a battery's life until it is recycled or otherwise disposed of. Moreover, principles of the present disclosure improve the operation of various computing devices, such as a mobile communications device and/or a battery monitor circuit, in numerous ways, for example: reducing the memory utilized by a battery monitor circuit via compact storage of battery history information in a novel matrix-like database, thus reducing manufacturing expense, operating current draw, and extending operational lifetime of the battery monitor circuit; facilitating monitoring and/or control of multiple monoblocs via a single mobile communications device, thus improving efficiency and throughput; and reducing the amount of data transmitted across a network linking one or more batteries and a remote device, thus freeing up the network to carry other transmitted data and/or to carry data of relevance more quickly, and also to significantly reduce communications costs.

Additionally, principles of the present disclosure improve the operation of devices coupled to and/or associated with a battery, for example a cellular radio base station, an electric forklift, an e-bike, and/or the like.

Yet further, application of principles of the present disclosure transform and change objects in the real world. For example, as part of an example algorithm, lead sulfate in a lead-acid monobloc is caused to convert to lead, lead oxide, and sulfuric acid via application of a charging current, thus transforming a partially depleted lead-acid battery into a more fully charged battery. Moreover, as part of another example algorithm, various monoblocs in a warehouse may be physically repositioned, recharged, or even removed from the warehouse or replaced, thus creating a new overall configuration of monoblocs in the warehouse.

It will be appreciated that various other approaches for monitoring, maintenance, and/or use of energy storage devices exist. As such, the systems and methods claimed herein do not preempt any such fields or techniques, but rather represent various specific advances offering technical improvements, time and cost savings, environmental benefits, improved battery life, and so forth. Additionally, it will be appreciated that various systems and methods disclosed herein offer such desirable benefits while, at the same time, eliminating a common, costly, power-draining component of prior monitoring systems - namely, a current sensor. Stated another way, various example systems and methods do not utilize, and are configured without, a current sensor and/or information available therefrom, in stark contrast to nearly all prior approaches.

In an exemplary embodiment, a battery monitor circuit is disclosed. The battery monitor circuit may be configured to sense, record, and/or wirelessly communicate certain information from and/or about a battery, for example date/time, voltage and temperature information from a battery.

In an exemplary embodiment, a monobloc is an energy storage device comprising at least one electrochemical cell, and typically a plurality of electrochemical cells. As used herein, the term "battery" can mean a single monobloc, or it can mean a plurality of monoblocs that are electrically connected in series and/or parallel. A "battery" comprising a plurality of monoblocs that are electrically connected in series and/or parallel is sometimes referred to in other literature as a "battery pack." A battery may comprise a positive terminal and a negative terminal. Moreover, in various exemplary embodiments, a battery may comprise a plurality of positive and negative terminals. In an exemplary embodiment, a battery monitor circuit is disposed within a battery, for example positioned or embedded inside a battery housing and connected to battery terminals via a wired connection.

In an embodiment, a battery monitor circuit comprises various electrical components, for example a voltage sensor, a temperature sensor, a processor for executing instructions, a memory for storing data and/or instructions, an antenna, and a transmitter / receiver / transceiver. In some exemplary embodiments, a battery monitor circuit may also include a clock, for example a real-time clock. Moreover, a battery monitor circuit may also include positioning components, for example a global positioning system (GPS) receiver circuit.

In certain example embodiments, a battery monitor circuit may comprise a voltage sensor configured with wired electrical connections to a battery, for monitoring a voltage between a positive terminal and a negative terminal (the terminals) of the battery. Moreover, the battery monitor circuit may comprise a temperature sensor for monitoring a temperature of (and/or associated with) the battery. The battery monitor circuit may comprise a processor for receiving a monitored voltage signal from the voltage sensor, for receiving a monitored temperature signal from the temperature sensor, for processing the monitored voltage signal and the monitored temperature signal, for generating voltage data and temperature data based on the monitored voltage signal and the monitored temperature signal, and for executing other functions and instructions.

In various example embodiments, the battery monitor circuit comprises a memory for storing data, for example voltage data and temperature data from (and/or associated with) a battery. Moreover, the memory may also store instructions for execution by the processor, data and/or instructions received from an external device, and so forth. In an exemplary embodiment, the voltage data represents the voltage across the terminals of the battery, and the temperature data represents a temperature as measured at a particular location in the battery. Yet further, the battery monitor circuit may comprise an antenna and a transceiver, for example for wirelessly communicating data, such as the voltage data and the temperature data to a remote device, and for receiving data and/or instructions. In one exemplary embodiment, the battery monitor circuit transmits the voltage data and the temperature data wirelessly via the antenna to the remote device.

The battery monitor circuit may be formed, in one exemplary embodiment, via coupling of various components to a circuit board. In an exemplary embodiment, the battery monitor circuit further incorporates a real-time clock. As primarily described herein, the battery monitor circuit may be positioned internal to the battery, and configured to sense an internal temperature of the battery. In another exemplary embodiment, a battery monitor circuit is positioned within a monobloc to sense an internal temperature of a monobloc. The wireless signals from the battery monitor circuit can be the basis for various useful actions and determinations as described further herein.

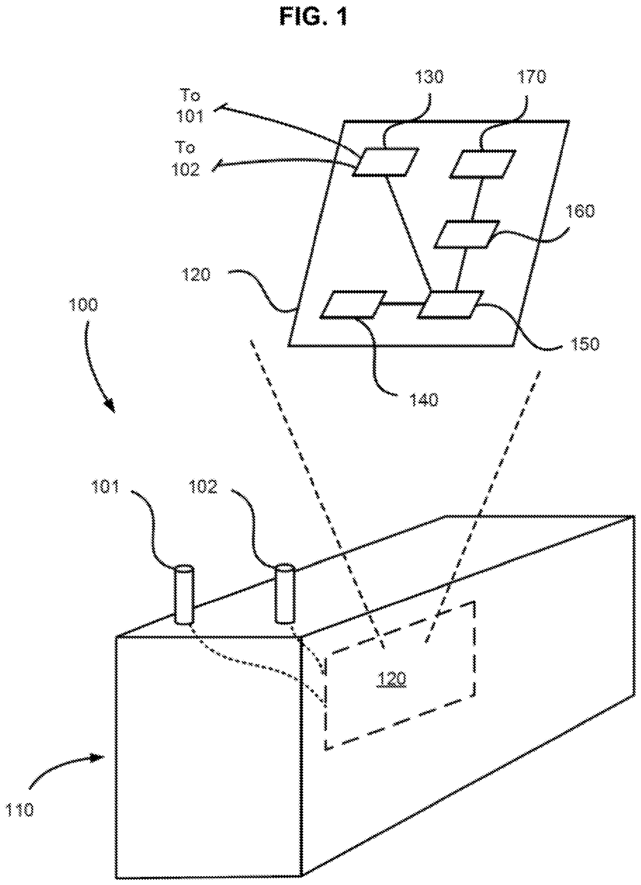

With reference now to FIG. 1, in an exemplary embodiment, a battery 100 may comprise a monobloc. The monobloc may, in an exemplary embodiment, be defined as an energy storage device. The monobloc comprises at least one electrochemical cell (not shown). In various example embodiments, the monobloc comprises multiple electrochemical cells, for example in order to configure the monobloc with a desired voltage and/or current capability. In various exemplary embodiments, the electrochemical cell(s) are lead-acid type electrochemical cells. Although any suitable lead-acid electrochemical cells may be used, in one exemplary embodiment, the electrochemical cells are of the absorbent glass mat (AGM) type design. In another exemplary embodiment, the lead-acid electrochemical cells are of the gel type of design. In another exemplary embodiment, the lead-acid electrochemical cells are of the flooded (vented) type of design. However, it will be appreciated that various principles of the present disclosure are applicable to various battery chemistries, including but not limited to nickel-cadmium (NiCd), nickel metal hydride (NiMH), lithium ion, lithium cobalt oxide, lithium iron phosphate, lithium ion manganese oxide, lithium nickel manganese cobalt oxide, lithium nickel cobalt aluminum oxide, lithium titanate, lithium sulphur, rechargeable alkaline, and/or the like, and thus the discussion herein directed to lead-acid batteries is provided by way of illustration and not of limitation.

The battery 100 may have a housing 110. For example, the battery 100 may be configured with a sealed monobloc lead-acid energy storage case made of a durable material. The battery 100 may further comprise a positive terminal 101 and a negative terminal 102. The sealed case may have openings through which the positive terminal 101 and negative terminal 102 pass.

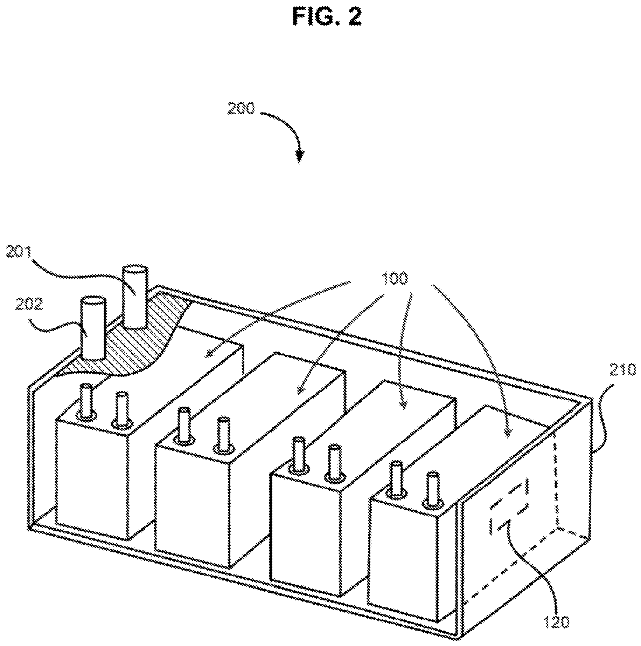

With reference now to FIG. 2, a battery 200 may comprise a plurality of electrically connected monoblocs, for example batteries 100. The monoblocs in the battery 200 may be electrically connected in parallel and/or series. In an exemplary embodiment, the battery 200 may comprise at least one string of monoblocs. In an exemplary embodiment, a first string may comprise a plurality of monoblocs electrically connected in series. In another exemplary embodiment, a second string may comprise a plurality of monoblocs electrically connected in series. If there is more than one string of monoblocs in the battery, the first, second, and/or additional strings may be electrically connected in parallel. A series/parallel connection of monoblocs may ultimately be connected to a positive terminal 201 and a negative terminal 202 of the battery 200, for example in order to achieve a desired voltage and/or current characteristic or capability for battery 200. Thus, in an exemplary embodiment, a battery 200 comprises more than one monobloc. A battery 200 may also be referred to herein as a power domain.

The battery 200 may have a cabinet or housing 210. For example, the battery 200 may comprise thermal and mechanical structures to protect the battery and provide a suitable environment for its operation.

With reference now to FIGS. 1 and 2, in an example application, a battery 100/200 may be used for back-up power (also known as an uninterrupted power supply or UPS). Moreover, the battery 100/200 may be used in a cellular radio base station application and may be connected to a power grid (e.g., to alternating current via a rectifier/inverter, to a DC microgrid, and/or the like). In another exemplary embodiment, the battery 100/200 is connected to an AC power grid and used for applications such as peak shaving, demand management, power regulation, frequency response, and/or reactive power supply. In another exemplary embodiment, the battery 100/200 is connected to a drive system providing motive power to various vehicles (such as bicycles), industrial equipment (such as forklifts), and on-road light, medium and heavy-duty vehicles. In other example applications, the battery 100/200 may be used for any suitable application where energy storage is desired on a short or long-term basis. The battery 100/200 may be shipped in commerce as a unitary article, shipped in commerce with other monoblocs, such as on a pallet with many other monoblocs), or shipped in commerce with other monoblocs as part of a battery (for example, multiple batteries 100 forming a battery 200).

In an exemplary embodiment, a battery monitor circuit 120 may be disposed within and internally connected to the battery 100. In an exemplary embodiment, a single battery monitor circuit 120 may be disposed within and associated with a single monobloc (see battery 100), as illustrated in FIG. 1. In another exemplary embodiment, more than one battery monitor circuit 120 is disposed within and connected to one or more portions of a single battery. For example, a first battery monitor circuit could be disposed within and connected to a first monobloc of the battery and a second battery monitor circuit could be disposed within and connected to a second monobloc of the battery.

The battery monitor circuit 120 may comprise a voltage sensor 130, a temperature sensor 140, a processor 150, a transceiver 160, an antenna 170, and a storage medium or memory (not shown in the Figures). In an exemplary embodiment, a battery monitor circuit 120 is configured to sense a voltage and temperature associated with a monobloc or battery 100, to store the sensed voltage and temperature in the memory together with an associated time of these readings, and to transmit the voltage and temperature data (with their associated time) from the battery monitor circuit 120 to one or more external locations.

In an exemplary embodiment, the voltage sensor 130 may be electrically connected by a wire to a positive terminal 101 of the battery 100 and by a wire to a negative terminal 102 of the battery 100. In an exemplary embodiment, the voltage sensor 130 is configured to sense a voltage of the battery 100. For example, the voltage sensor 130 may be configured to sense the voltage between the positive terminal 101 and the negative terminal 102. In an exemplary embodiment, the voltage sensor 130 comprises an analog to digital converter. However, any suitable device for sensing the voltage of the battery 100 may be used.

In an exemplary embodiment, the temperature sensor 140 is configured to sense a temperature measurement of the battery 100. In one exemplary embodiment, the temperature sensor 140 may be configured to sense a temperature measurement at a location in or inside of the battery 100. The location where the temperature measurement is taken can be selected such that the temperature measurement is reflective of the temperature of the electrochemical cells comprising battery 100. In various exemplary embodiments, the battery monitor circuit 120 is configured to be located inside of the battery 100. Moreover, in various exemplary embodiments the presence of battery monitor circuit 120 within battery 100 may not be visible or detectable via external visual inspection of battery 100.

In an exemplary embodiment, the temperature sensor 140 comprises a thermocouple, a thermistor, a temperature sensing integrated circuit, and/or the like embedded in the battery.

In an exemplary embodiment, the battery monitor circuit 120 comprises a printed circuit board for supporting and electrically coupling a voltage sensor, temperature sensor, processor, storage medium, transceiver, antenna, and/or other suitable components. In another exemplary embodiment, the battery monitor circuit 120 includes a housing (not shown). The housing can be made of any suitable material for protecting the electronics in the battery monitor circuit 120, for example a durable plastic. The housing can be made in any suitable shape or form factor. In an exemplary embodiment, the housing of battery monitor circuit 120 is configured to be disposed inside battery 100, and may be secured, for example via adhesive, potting material, bolts, screws, clamps, and/or the like. Moreover, any suitable attachment device or method can be used to keep the battery monitor circuit 120 in a desired position and/or orientation within battery 100. In this manner, as battery 100 is transported, installed, utilized, and so forth, battery monitor circuit 120 remains securely disposed therein and operable in connection therewith.

In an exemplary embodiment, the battery monitor circuit 120 further comprises a real-time clock capable of maintaining time referenced to a standard time such as Universal Time Coordinated (UTC), independent of any connection (wired or wireless) to an external time standard such as a time signal accessible via a public network such as the Internet. The clock is configured to provide the current time/date (or a relative time) to the processor 150. In an exemplary embodiment, the processor 150 is configured to receive the voltage and temperature measurement and to store, in the storage medium, the voltage and temperature data associated with the time that the data was sensed/stored. In an exemplary embodiment, the voltage, temperature and time data may be stored in a storage medium in the form of a database, a flat file, a blob of binary, or any other suitable format or structure. Moreover, the processor 150 may be configured to store additional data in a storage medium in the form of a log. For example, the processor may log each time the voltage and/or temperature changes by a settable amount. In an exemplary embodiment, the processor 150 compares the last measured data to the most recent measured data, and logs the recent measured data only if it varies from the last measured data by at least this settable amount. The comparisons can be made at any suitable interval, for example every second, every 5 seconds, every 10 seconds, every 30 seconds, every minute, every 10 minutes, and/or the like. The storage medium may be located on the battery monitor circuit 120, or may be remote. The processor 150 may further be configured to wirelessly transmit the logged temperature/voltage data to a remote device for additional analysis, reporting, and/or action. In an exemplary embodiment, the remote device may be configured to stitch the transmitted data log together with the previously transmitted logs, to form a log that is continuous in time. In this manner, the size of the log (and the memory required to store it) on the battery monitor circuit 120 can be minimized. The processor 150 may further be configured to receive instructions from a remote device. The processor 150 may also be configured to transmit the time, temperature and voltage data off of the battery monitor circuit 120 by providing the data in a signal to the transceiver 160.

In another exemplary embodiment, the battery monitor circuit 120 is configured without a real-time clock. Instead, data is sampled on a consistent time interval controlled by the processor 150. Each interval is numbered sequentially with a sequence number to uniquely identify it. Sampled data may all be logged; alternatively, only data which changes more than a settable amount may be logged. Periodically, when the battery monitor circuit 120 is connected to a time standard, such as the network time signal accessible via the Internet, the processor time is synchronized with real-time represented by the time standard. However, in both cases, the interval sequence number during which the data was sampled is also logged with the data. This then fixes the time interval between data samples without the need for a real-time clock on battery monitor circuit 120. Upon transmission of the data log to a remote device, the intervals are synchronized with the remote device (described further herein), which maintains real time (e.g., UTC), for example synchronized over an Internet connection. Thus, the remote device is configured to provide time via synchronization with the battery monitor circuit 120 and processor 150. The data stored at the battery monitor circuit 120 or at the remote device may include the cumulative amount of time a monobloc has spent at a particular temperature and/or voltage. The processor 150 may also be configured to transmit the cumulative time, temperature and voltage data from the battery monitor circuit 120 by providing the data in a signal to the transceiver 160.

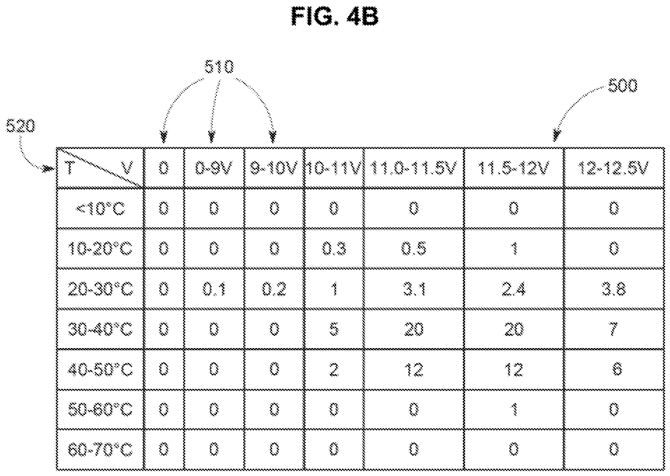

In an exemplary embodiment, the time, temperature and voltage data for a battery may be stored in a file, database or matrix that, for example, comprises a range of voltages on one axis and a range of temperatures on a second axis, wherein the cells of this table are configured to increment a counter in each cell to represent the amount of time a battery has spent in a particular voltage/temperature state (i.e., to form a battery operating history matrix). The battery operating history matrix can be stored in the memory of battery monitor circuit 120 and/or in a remote device. For example, and with brief reference to FIG. 4B, an example battery operating history matrix 450 may comprise columns 460, with each column representing a particular voltage or range of voltage measurements. For example, the first column may represent a voltage range from 0 volts to 1 volt, the second column may represent a voltage range from 1 volt to 9 volts, the third column may represent a voltage range from 9 volts to 10 volts, and so forth. The battery operating history matrix 450 may further comprise rows 470, with each row representing a particular temperature (+/-) or range of temperature measurements. For example, the first row may represent a temperature less than 10 °C, the second row may represent a temperature range from 10 °C to 20 °C, the third row may represent a temperature range from 20 °C to 30 °C, and so forth. Any suitable scale and number of columns/rows can be used. In an exemplary embodiment, the battery operating history matrix 450 stores a cumulative history of the amount of time the battery has been in each designated voltage/temperature state. In other words, the battery operating history matrix 450 aggregates (or correlates) the amount of time the battery has been in a particular voltage/temperature range. In particular, such a system is particularly advantageous because the storage size does not increase (or increases only a marginal amount) regardless of how long it records data. The memory occupied by the battery operating history matrix 450 is often the same size the first day it begins aggregating voltage/temperature data as its size years later or near a battery's end of life. It will be appreciated that this technique reduces, compared to implementations that do not use this technique, the size of the memory and the power required to store this data, thus significantly improving the operation of the battery monitor circuit 120 computing device. Moreover, battery voltage/temperature data may be transmitted to a remote device on a periodic basis. This effectively gates the data, and, relative to non-gating techniques, reduces the power required to store data and transmit data, reduces the size of the memory, and reduces the data transmission time.

In an exemplary embodiment, the transceiver 160 may be any suitable transmitter and/or receiver. For example, the transceiver 160 may be configured to up-convert the signal to transmit the signal via the antenna 170 and/or to receive a signal from the antenna 170 and down-convert the signal and provide it to the processor 150. In an exemplary embodiment, the transceiver 160 and/or the antenna 170 can be configured to wirelessly send and receive signals between the battery monitor circuit 120 and a remote device. The wireless transmission can be made using any suitable communication standard, such as radio frequency communication, Wi-Fi, Bluetooth^{®}, Bluetooth Low Energy (BLE), Bluetooth Low Power (IPv6/6LoWPAN), a cellular radio communication standard (2G, 3G, 4G LTE, 5G, etc.), and/or the like. In an exemplary embodiment, the wireless transmission is made using low power, short range signals, to keep the power drawn by the battery monitor circuit low. In one exemplary embodiment, the processor 150 is configured to wake-up, communicate wirelessly, and go back to sleep on a schedule suitable for minimizing or reducing power consumption. This is desirable to prevent monitoring of the battery via battery monitor circuit 120 from draining the battery prematurely. The battery monitor circuit 120 functions, such as waking/sleeping and data gating functions, facilitate accurately sensing and reporting the temperature and voltage data without draining the battery 100. In various exemplary embodiments, the battery monitor circuit 120 is powered by the battery within which it is disposed and to which it is coupled for monitoring.

In some exemplary embodiments, use of a Bluetooth protocol facilitates a single remote device receiving and processing a plurality of signals correlated with a plurality of batteries (each equipped with a battery monitor circuit 120), and doing so without signal interference. This one-to-many relationship between a remote device and a plurality of batteries, each equipped with a battery monitor circuit 120, is a distinct advantage for monitoring of batteries in storage and shipping channels.

In an exemplary embodiment, battery monitor circuit 120 is located internal to the battery. For example, battery monitor circuit 120 may be disposed within a housing of battery 100. In various embodiments, battery monitor circuit 120 is located internal to a monobloc or battery. Battery monitor circuit 120 may be hidden from view / inaccessible from the outside of battery 100. This may prevent tampering by a user and thus improve the reliability of the reporting performed. Battery monitor circuit 120 may be positioned just below a lid of battery 100, proximate the interconnect straps (lead inter-connecting bar), or the like. In this manner, temperature of a monobloc due to the electrochemical cells and heat output of the interconnect straps can be accurately measured.

In an exemplary embodiment, temperature sensor 140 may be configured to sense a temperature of one of the terminals of a monobloc. In this manner, the temperature sensed by the battery monitor circuit 120 may be more representative of the temperature of battery 100 and/or the electrochemical cells therein. In some embodiments, temperature sensor 140 may be located on and/or directly coupled to the printed circuit board of battery monitor circuit 120. Moreover, the temperature sensor 140 may be located in any suitable location inside of a monobloc or battery for sensing a temperature associated with the monobloc or battery.

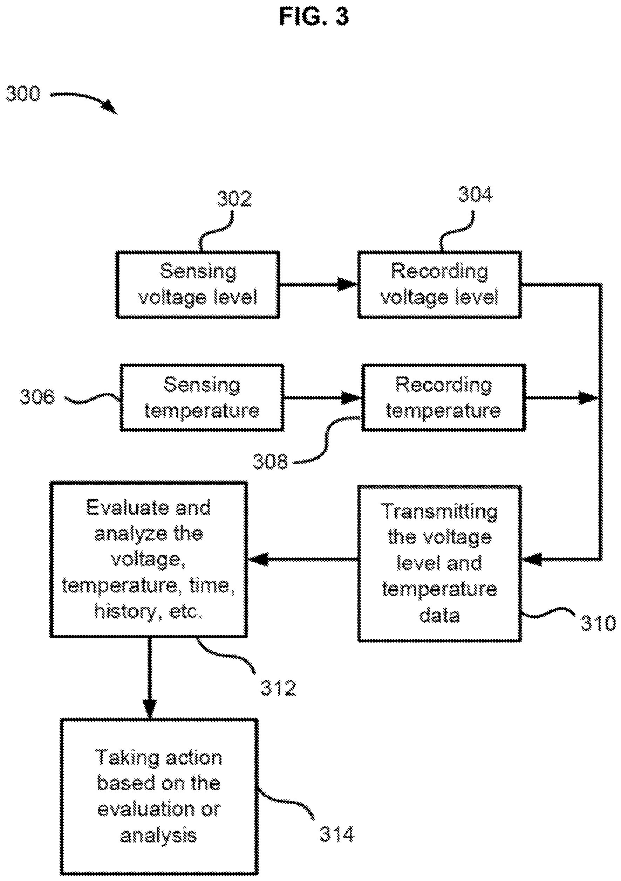

Thus, with reference now to FIG. 3, an exemplary method 300 for monitoring a battery 100 comprising at least one electrochemical cell comprises: sensing a voltage of the battery 100 with a voltage sensor 130 wired to the battery terminals (step 302), and recording the voltage and the time that the voltage was sensed in a storage medium (step 304); sensing a temperature associated with battery 100 with a temperature sensor 140 disposed within battery 100 (step 306), and recording the temperature and the time that the temperature was sensed in the storage medium (step 308); and wirelessly transmitting the voltage, temperature and time data recorded in the storage medium to a remote device (step 310). The voltage, temperature, and time data, together with other relevant data, may be assessed, analyzed, processed, and/or utilized as an input to various computing systems, resources, and/or applications (step 312). In this exemplary method, the voltage sensor 130, temperature sensor 140, and storage medium are located inside the battery 100 on a battery monitor circuit 120. Moreover, method 300 may comprise taking various actions in response to the voltage, temperature, and/or time data (step 314), for example charging a battery, discharging a battery, removing a battery from a warehouse, replacing a battery with a new battery, and/or the like.

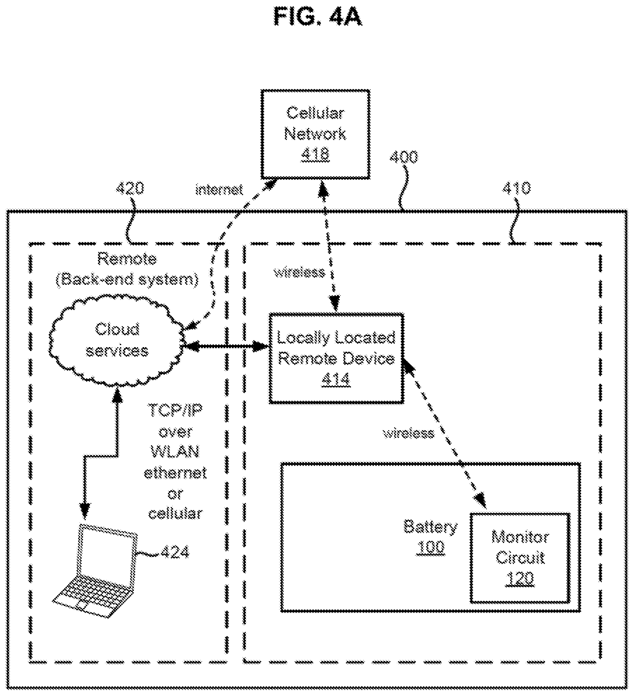

With reference now to FIG. 4A, in an exemplary embodiment, the battery monitor circuit 120 is configured to communicate data with a remote device. The remote device may be configured to receive data from a plurality of batteries, with each battery equipped with a battery monitor circuit 120. For example, the remote device may receive data from individual batteries 100, each connected to a battery monitor circuit 120.

An example system 400 is disclosed for collecting and using data associated with each battery 100/200. In general, the remote device is an electronic device that is not physically part of the battery 100/200 or the battery monitor circuit 120. The system 400 may comprise a local portion 410 and/or a remote portion 420. The local portion 410 comprises components located relatively near the battery or batteries 100/200. "Relatively near," in one exemplary embodiment, means within wireless signal range of the battery monitor circuit antenna. In another example embodiment, "relatively near" means within Bluetooth range, within the same cabinet, within the same room, and the like. The local portion 410 may comprise, for example, one or more batteries 100/200, a battery monitor circuit 120, and optionally a locally located remote device 414 located in the local portion 410. Moreover, the local portion may comprise, for example, a gateway. The gateway may be configured to receive data from each battery 100. The gateway may also be configured to transmit instructions to each battery 100. In an example embodiment, the gateway comprises an antenna for transmitting / receiving wirelessly at the gateway and/or for communicating with a locally located remote device 414. The locally located remote device 414, in an exemplary embodiment, is a smartphone, tablet, or other electronic mobile device. In another exemplary embodiment, the locally located remote device 414 is a computer, a network, a server, or the like. In a further exemplary embodiment, the locally located remote device 414 is an onboard vehicle electronics system. Yet further, in some embodiments, the gateway may function as locally located remote device 414. Exemplary communications, for example between the gateway and locally located remote device 414, may be via any suitable wired or wireless approach, for example via a Bluetooth protocol.

In some exemplary embodiments, the remote device is not located in the local portion 410, but is located in the remote portion 420. The remote portion 420 may comprise any suitable back-end systems. For example, the remote device in the remote portion 420 may comprise a computer 424 (e.g., a desktop computer, a laptop computer, a server, a mobile device, or any suitable device for using or processing the data as described herein). The remote portion may further comprise cloud-based computing and/or storage services, on-demand computing resources, or any suitable similar components. Thus, the remote device, in various exemplary embodiments, may be a computer 424, a server, a back-end system, a desktop, a cloud system, or the like.

In an exemplary embodiment, the battery monitor circuit 120 may be configured to communicate data directly between battery monitor circuit 120 and the locally located remote device 414. In an exemplary embodiment, the communication between the battery monitor circuit 120 and the locally located remote device 414 can be a wireless transmission, such as via Bluetooth transmission. Moreover, any suitable wireless protocol can be used.

In an exemplary embodiment, the battery monitor circuit 120 further comprises a cellular modem for communicating via a cellular network 418 and other networks, such as the Internet, with the remote device. For example, data may be shared with the computer 424 or with the locally located remote device 414 via the cellular network 418. Thus, battery monitor circuit 120 may be configured to send temperature and voltage data to the remote device and receive communications from the remote device, via the cellular network 418 to other networks, such as the Internet, for distribution anywhere in the Internet connected world.

In various exemplary embodiments, the data from the local portion 410 is communicated to the remote portion 420. For example, data and/or instructions from the battery monitor circuit 120 may be communicated to a remote device in the remote portion 420. In an exemplary embodiment, the locally located remote device 414 may communicate data and/or instructions with the computer 424 in the remote portion 420. In an exemplary embodiment, these communications are sent over the Internet. The communications may be secured and/or encrypted, as desired, in order to preserve the security thereof.

In an exemplary embodiment, these communications may be sent using any suitable communication protocol, for example, via TCP/IP, WLAN, over Ethernet, WiFi, cellular radio, or the like. In one exemplary embodiment, the locally located remote device 414 is connected through a local network by a wire to the Internet and thereby to any desired remotely located remote device. In another exemplary embodiment, the locally located remote device 414 is connected through a cellular network, for example cellular network 418, to the Internet and thereby to any desired remotely located remote device.

In an exemplary embodiment, this data may be received at a server, received at a computer 424, stored in a cloud-based storage system, on servers, in databases, or the like. In an exemplary embodiment, this data may be processed by the battery monitor circuit 120, the locally located remote device 414, the computer 424, and/or any suitable remote device. Thus, it will be appreciated that processing and analysis described as occurring in the battery monitor circuit 120 may also occur fully or partially in the battery monitor circuit 120, the locally located remote device 414, the computer 424, and/or any other remote device.

The remote portion 420 may be configured, for example, to display, process, utilize, or take action in response to, information regarding many batteries 100/200 that are geographically dispersed from one another and/or that include a diverse or differing types, groups, and/or sets of batteries 100/200. The remote portion 420 can display information about, or based on, specific individual battery temperature and/or voltage. Thus, the system can monitor a large group of batteries 100/200 located great distances from each other, but do so on an individual battery level.

The remote portion 420 device may be networked such that it is accessible from anywhere in the world. Users may be issued access credentials to allow their access to only data pertinent to batteries owned or operated by them. In some embodiments, access control may be provided by assigning a serial number to the remote device and providing this number confidentially to the battery owner or operator to log into.

Voltage, temperature and time data stored in a cloud-based system may be presented in various displays to convey information about the status of a battery, its condition, its operating requirement(s), unusual or abnormal conditions, and/or the like. In one embodiment, data from one battery or group of batteries may be analyzed to provide additional information, or correlated with data from other batteries, groups of batteries, or exogenous conditions to provide additional information.

Systems and methods disclosed herein provide an economical means for monitoring the performance and health of batteries located anywhere in the cellular radio or Internet connected world. As battery monitor circuits 120 rely on only voltage, temperature and time data to perform (or enable performance of) these functions, cost is significantly less than various prior art systems which must monitor battery current as well. Further, performance of calculations and analyses in a remote device, which is capable of receiving voltage, temperature and time data from a plurality of monitoring circuits connected to a plurality of batteries, rather than performing these functions at each battery in the plurality of batteries, minimizes the per battery cost to monitor any one battery, analyze its performance and health, and display the results of such analyses. This allows effective monitoring of batteries, critical to various operations but heretofore not monitored because an effective remote monitoring system was unavailable and/or the cost to monitor batteries locally and collect data manually was prohibitive. Example systems allow aggregated remote monitoring of batteries in such example applications as industrial motive power (forklifts, scissor lifts, tractors, pumps and lights, etc.), low speed electric vehicles (neighborhood electric vehicles, electric golf carts, electric bikes, scooters, skateboards, etc.), grid power backup power supplies (computers, emergency lighting, and critical loads remotely located), marine applications (engine starting batteries, onboard power supplies), automotive applications, and/or other example applications (for example, engine starting batteries, over-the-road truck and recreational vehicle onboard power, and the like). This aggregated remote monitoring of like and/or disparate batteries in like and/or disparate applications allows the analysis of battery performance and health (e.g., battery state-of-charge, battery reserve time, battery operating mode, adverse thermal conditions, and so forth), that heretofore was not possible. Using contemporaneous voltage and temperature data, stored voltage and temperature data, and/or battery and application specific parameters (but excluding data regarding battery 100/200 current), the short term changes in voltage and/or temperature, longer term changes in voltage and/or temperature, and thresholds for voltage and/or temperature may be used singularly or in combination to conduct exemplary analyses, such as in the battery monitor circuit 120, the locally located remote device 414, the computer 424, and/or any suitable device. The results of these analyses, and actions taken in response thereto, can increase battery performance, improve battery safety and reduce battery operating costs.

While many of the embodiments herein have focused on electrochemical cell(s) which are lead-acid type electrochemical cells, in other embodiments the electrochemical cells may be of various chemistries, including but not limited to, lithium, nickel, cadmium, sodium and zinc. In such embodiments, the battery monitor circuit and/or the remote device may be configured to perform calculations and analyses pertinent to that specific battery chemistry.

In some example embodiments, via application of principles of the present disclosure, outlier batteries can be identified and alerts or notices provided by the battery monitor circuit 120 and/or the remote device to prompt action for maintaining and securing the batteries. The batteries 100/200 may be made by different manufacturers, made using different types of construction or different types of cells. However, where multiple batteries 100/200 are constructed in similar manner and are situated in similar environmental conditions, the system may be configured to identify outlier batteries, for example batteries that are returning different and/or suspect temperature and/or voltage data. This outlier data may be used to identify failing batteries or to identify local conditions (high load, or the like) and to provide alerts or notices for maintaining and securing such batteries. Similarly, batteries 100/200 in disparate applications or from disparate manufacturers can be compared to determine which battery types and/or manufacturers products perform best in any particular application.

In an exemplary embodiment, the battery monitor circuit 120 and/or the remote device may be configured to analyze the data and take actions, send notifications, and make determinations based on the data. The battery monitor circuit 120 and/or the remote device may be configured to show a present temperature for each battery 100 and/or a present voltage for each battery 100. Moreover, this information can be shown with the individual measurements grouped by temperature or voltage ranges, for example for prompting maintenance and safety actions by providing notification of batteries that are outside of a pre-determined range(s) or close to being outside of such range.

Moreover, the battery monitor circuit 120 and/or the remote device can display the physical location of each battery 100 (as determined by the battery monitor circuit 120) for providing inventory management of the batteries or for securing the batteries. In one exemplary embodiment, the physical location information is determined by the battery monitor circuit 120 using the Global Positioning System (GPS) via a GPS receiver installed in the battery monitor circuit 120. This location information can be stored with the voltage, temperature, and time data. In another exemplary embodiment, the location data is shared wirelessly with the remote device, and the remote device is configured to store the location data. The location data may be stored in conjunction with the time, to create a travel history (location history) for the monobloc that reflects where the monobloc or battery has been over time.

Moreover, the remote device can be configured to create and/or send notifications based on the data. For example, a notification can be displayed if, based on analysis in the battery monitor circuit and/or the remote device a specific monobloc is over voltage, the notification can identify the specific monobloc that is over voltage, and the system can prompt maintenance action. Notifications may be sent via any suitable system or means, for example via e-mail, SMS message, telephone call, in-application prompt, or the like.

In an exemplary embodiment, where the battery monitor circuit 120 has been disposed within and connected to a battery 100, the system provides inventory and maintenance services for the battery 100/200. For example, the system may be configured to detect the presence of a monobloc or battery in storage or transit, without touching the monobloc or battery. The battery monitor circuit 120 can be configured, in an exemplary embodiment, for inventory tracking in a warehouse. In one exemplary embodiment, the battery monitor circuit 120 transmits location data to the locally located remote device 414 and/or a remotely located remote device and back-end system configured to identify when a specific battery 100/200 has left the warehouse or truck, for example unexpectedly. This may be detected, for example, when battery monitor circuit 120 associated with the battery 100 ceases to communicate voltage and/or temperature data with the locally located remote device 414 and/or back end system, when the battery location is no longer where noted in a location database, or when the wired connection between the monobloc or battery and the battery monitor circuit 120 is otherwise severed. The remote back end system is configured, in an exemplary embodiment, to trigger an alert that a battery may have been stolen. The remote back end system may be configured to trigger an alert that a battery is in the process of being stolen, for example as successive monoblocs in a battery stop (or lose) communication or stop reporting voltage and temperature information. In an exemplary embodiment, wherein the battery monitor circuit 120 is configured with Bluetooth communications, a remote back end system may be configured to identify if the battery 100/200 leaves a warehouse unexpectedly and, in that event, to send an alarm, alert, or notification. These various embodiments of theft detection and inventory tracking are unique as compared to prior approaches, for example, because they can occur at greater distance than RFID type querying of individual objects, and thus can reflect the presence of objects that are not readily observable (e.g., inventory stacked in multiple layers on shelves or pallets) where RFID would not be able to provide similar functionality.

In some exemplary embodiments, the remote device (e.g., the locally located remote device 414) is configured to remotely receive data regarding the voltage and temperature of each battery 100. In an exemplary embodiment, the remote device is configured to remotely receive voltage, temperature, and time data from each battery monitor circuit 120 associated with each battery 100 of a plurality of batteries. These batteries may, for example, be inactive or non-operational. For example, these batteries may not yet have been installed in an application, connected to a load, or put in service. The system may be configured to determine which batteries need re-charging. These batteries may or may not be contained in shipping packaging. However, because the data is received and the determination is made remotely, the packaged batteries do not need to be unpackaged to receive this data or make the determination. So long as a battery monitor circuit 120 is disposed within and coupled to these batteries, these batteries may be located in a warehouse, in a storage facility, on a shelf, or on a pallet, but the data can be received and the determination made without unpacking, unstacking, touching or moving any of the plurality of batteries. These batteries may even be in transit, such as on a truck or in a shipping container, and the data can be received and the determination made during such transit. Thereafter, at an appropriate time, for example upon unpacking a pallet, the battery or batteries needing re-charging may be identified and charged.

In a further exemplary embodiment, the process of "checking" a battery may be described herein as receiving voltage data and temperature data (and potentially, time data) associated with a battery, and presenting information to a user based on this data, wherein the information presented is useful for making a determination or assessment about the battery. In an exemplary embodiment, the remote device is configured to remotely "check" each battery 100 of a plurality of batteries equipped with battery monitor circuit 120. In this exemplary embodiment, the remote device can receive wireless signals from each of the plurality of batteries 100, and check the voltage and temperature of each battery 100. Thus, in these exemplary embodiments, the remote device can be used to quickly interrogate a pallet of batteries that are awaiting shipment to determine if any battery needs to be recharged, how long until a particular battery will need to be re-charged, or if any state of health issues are apparent in a particular battery, all without un-packaging or otherwise touching the pallet of batteries. This checking can be performed, for example, without scanning, pinging, moving or individually interrogating the packaging or batteries, but rather based on the battery monitor circuit 120 associated with each battery 100 wirelessly reporting the data to the remote device (e.g., 414/424).

In an exemplary embodiment, the battery 100 is configured to identify itself electronically. For example, the battery 100 may be configured to communicate a unique electronic identifier (unique serial number, or the like) from the battery monitor circuit 120 to the remote device, or the locally located remote device 414. This serial number may be correlated with a visible battery identifier (e.g., label, barcode, QR code, serial number, or the like) visible on the outside of the battery, or electronically visible by means of a reader capable of identifying a single battery in a group of batteries. Therefore, the system 400 may be configured to associate battery data from a specific battery with a unique identifier of that specific battery. Moreover, during installation of a monobloc, for example battery 100, in a battery 200, an installer may enter into a database associated with system 400 various information about the monobloc, for example relative position (e.g., what battery, what string, what position on a shelf, the orientation of a cabinet, etc.). Similar information may be entered into a database regarding a battery 100.

Thus, if the data indicates a battery of interest (for example, one that is performing subpar, overheating, discharged, etc.), that particular battery can be singled out for any appropriate action. Stated another way, a user can receive information about a specific battery (identified by the unique electronic identifier), and go directly to that battery (identified by the visible battery identifier) to attend to any needs it may have (perform "maintenance"). For example, this maintenance may include removing the identified battery from service, repairing the identified battery, charging the identified battery, etc. In a specific exemplary embodiment, a battery 100/200 may be noted as needing to be re-charged, a warehouse employee could scan the batteries on the shelves in the warehouse (e.g., scanning a QR code on each battery 100/200) to find the battery of interest and then recharge it. In another exemplary embodiment, as the batteries are moved to be shipped, and the package containing the battery moves along a conveyor, past a reader, the locally located remote device 414 can be configured to retrieve the data on that specific battery, including the unique electronic identifier, voltage and temperature, and alert if some action needs to be taken with respect to it (e.g., if the battery needs to be recharged before shipment).

In an exemplary embodiment, the battery monitor circuit 120 itself, the remote device and/or any suitable storage device can be configured to store the battery operation history of the individual battery 100/200 through more than one phase of the battery's life. In an exemplary embodiment, the history of the battery can be recorded. In an exemplary embodiment, the battery may further record data after it is integrated into a product or placed in service (alone or in a battery). The battery may record data after it is retired, reused in a second life application, and/or until it is eventually recycled or disposed.

Although sometimes described herein as storing this data on the battery monitor circuit 120, in a specific exemplary embodiment, the historical data is stored remotely from the battery monitor circuit 120. For example, the data described herein can be stored in one or more databases remote from the battery monitor circuit 120 (e.g., in a cloud-based storage offering, at a back-end server, at the gateway, and/or on one or more remote devices).

The system 400 may be configured to store, during one or more of the aforementioned time periods, the history of how the battery has been operated, the environmental conditions in which it has been operated, and/or the society it has kept with other batteries, as may be determined based on the data stored during these time periods. For example, the remote device may be configured to store the identity of other batteries that were electrically associated with the battery 100/200, such as if two batteries are used together in one application. This shared society information may be based on the above described unique electronic identifier and data identifying where (geographically) the battery is located. The remote device may further store when the batteries shared in a particular operation.

This historical information, and the analyses that are performed using it, can be based solely on the voltage, temperature and time data. Stated another way, current data is not utilized. As used herein, "time" may include the date, hour, minute, and/or second of a voltage/temperature measurement. In another exemplary embodiment, "time" may mean the amount of time that the voltage/temperature condition existed. In particular, the history is not based on data derived from the charge and discharge currents associated with the battery(s). This is particularly significant because it would be very prohibitive to connect to and include a sensor to measure the current for each and every monobloc, and an associated time each was sensed from the individual battery, where there is a large number of monoblocs.

In various exemplary embodiments, system 400 (and/or components thereof) may be in communication with an external battery management system (BMS) coupled one or more batteries 100/200, for example over a common network such as the Internet. System 400 may communicate information regarding one or more batteries 100/200 to the BMS and the BMS may take action in response thereto, for example by controlling or modifying current into and/or out of one or more batteries 100/200, in order to protect batteries 100/200.

In an exemplary embodiment, in contrast to past solutions, system 400 is configured to store contemporaneous voltage and/or contemporaneous temperature data relative to geographically dispersed batteries. This is a significant improvement over past solutions where there is no contemporaneous voltage and/or contemporaneous temperature data available on multiple monoblocs or batteries located in different locations and operating in different conditions. Thus, in the exemplary embodiment, historical voltage and temperature data is used to assess the condition of the monoblocs or batteries and/or make predictions about and comparisons of the future condition of the monobloc or battery. For example, the system may be configured to make assessments based on comparison of the data between the various monoblocs in a battery 200. For example, the stored data may indicate the number of times a monobloc has made an excursion out of range (over charge, over voltage, over temperature, etc.), when such occurred, how long it persisted, and so forth.

In an exemplary embodiment, the battery monitor circuit 120 is located such that it is not viewable / accessible from the outside of battery 100. Battery monitor circuit 120 is located internal to the battery 100 in a location that facilitates measurement of an internal temperature of the battery 100.

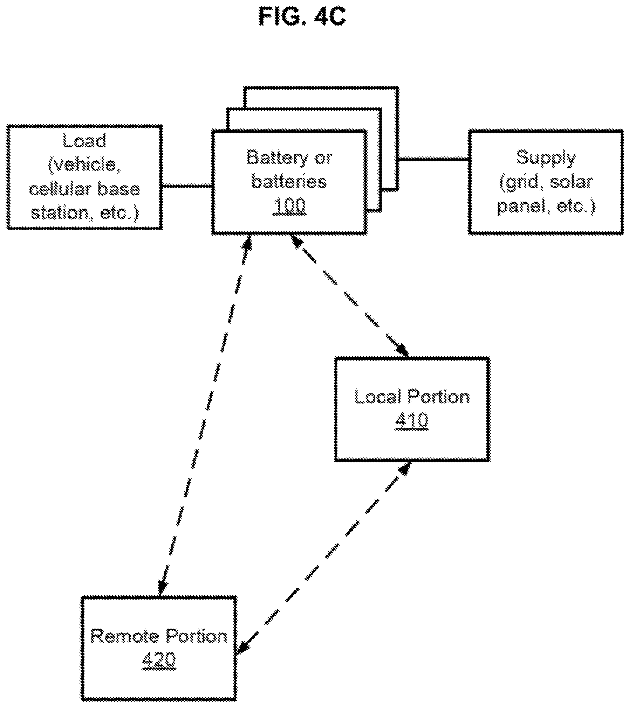

With reference now to FIG. 4C, in various exemplary embodiments a battery 100 having a battery monitor circuit 120 disposed therein may be coupled to a load and/or to a power supply. For example, battery 100 may be coupled to a vehicle to provide electrical energy for motive power. Additionally and/or alternatively, battery 100 may be coupled to a solar panel to provide a charging current for battery 100. Moreover, in various applications battery 100 may be coupled to an electrical grid. It will be appreciated that the nature and number of systems and/or components to which battery 100/200 is coupled may impact desired approaches for monitoring of battery 100/200, for example via application of various methods, algorithms, and/or techniques as described herein. Yet further, in various applications and methods disclosed herein, battery 100/200 is not coupled to any external load or a charging source, but is disconnected (for example, when sitting in storage in a warehouse).

For example, various systems and methods may utilize information specific to the characteristics of battery 100/200 and/or the specific application in which battery 100/200 is operating. For example, battery 100/200 and application specific characteristics may include the manufacture date, the battery capacity, and recommended operating parameters such as voltage and temperature limits. In an example embodiment, battery and application specific characteristics may be the chemistry of battery 100/200 - e.g., absorptive glass mat lead acid, gelled electrolyte lead acid, flooded lead acid, lithium manganese oxide, lithium cobalt oxide, lithium iron phosphate, lithium nickel manganese cobalt, lithium cobalt aluminum, nickel zinc, zinc air, nickel metal hydride, nickel cadmium, and/or the like.

In an example embodiment, battery specific characteristics may be the battery manufacturer, model number, battery capacity in ampere-hours (Ah), nominal voltage, float voltage, state of charge v. open circuit voltage, state of charge, voltage on load, and/or equalized voltage, and so forth. Moreover, the characteristics can be any suitable specific characteristic of battery 100/200.

In various exemplary embodiments, application specific characteristics may identify the application as a cellular radio base station, an electric forklift, an e-bike, and/or the like. More generally, application specific characteristics may distinguish between grid-coupled applications and mobile applications.

In various example embodiments, information characterizing battery 100/200 can be input by: manually typing the information: into a software program running on a mobile device, into a web interface presented by a server to a computer or mobile device, or any other suitable manual data entry method. In other example embodiments, information characterizing battery 100/200 can be selected from a menu or checklist (e.g., selecting the supplier or model of a battery from a menu). In other example embodiments, information can be received by scanning a QR code on the battery. In other example embodiments, information characterizing battery 100/200 can be stored in one or more databases (e.g., by the users providing an identifier that links to a database storing this information). For example, databases such as Department of Motor Vehicles, battery manufacturer and OEM databases, fleet databases, and other suitable databases may have parameters and other information useful for characterizing the application of a battery or batteries 100/200. Moreover, the characteristics can be any suitable application specific characteristic.

In one example embodiment, if battery 100 is configured with a battery monitor circuit 120 therewithin, battery and application specific characteristics can be programmed onto the circuitry (e.g., in a battery parameters table). In this case, these characteristics for each battery 100 travel with battery 100 and can be accessed by any suitable system performing the analysis described herein. In another example embodiment, the battery and application specific characteristics can be stored remote from battery 100/200, for example in the remote device. Moreover, any suitable method for receiving information characterizing battery 100/200 may be used. In an example embodiment, the information can be stored on a mobile device, on a data collection device (e.g., a gateway), or in the cloud. Moreover, exemplary systems and methods may be further configured to receive, store, and utilize specific characteristics related to a battery charger (e.g., charger manufacturer, model, current output, charge algorithm, and/or the like).

The various system components discussed herein may include one or more of the following: a host server or other computing systems including a processor for processing digital data; a memory coupled to the processor for storing digital data; an input digitizer coupled to the processor for inputting digital data; an application program stored in the memory and accessible by the processor for directing processing of digital data by the processor; a display device coupled to the processor and memory for displaying information derived from digital data processed by the processor; and a plurality of databases. Various databases used herein may include: temperature data, time data, voltage data, battery location data, battery identifier data, and/or like data useful in the operation of the system. As those skilled in the art will appreciate, a computer may include an operating system (e.g., Windows offered by Microsoft Corporation, MacOS and/or iOS offered by Apple Computer, Linux, Unix, and/or the like) as well as various conventional support software and drivers typically associated with computers.

The present system or certain part(s) or function(s) thereof may be implemented using hardware, software, or a combination thereof, and may be implemented in one or more computer systems or other processing systems. However, the manipulations performed by embodiments were often referred to in terms, such as matching or selecting, which are commonly associated with mental operations performed by a human operator. No such capability of a human operator is necessary, or desirable in most cases, in any of the operations described herein. Rather, the operations may be machine operations, or any of the operations may be conducted or enhanced by artificial intelligence (Al) or machine learning. Useful machines for performing certain algorithms of various embodiments include general purpose digital computers or similar devices.

In fact, in various embodiments, the embodiments are directed toward one or more computer systems capable of carrying out the functionality described herein. The computer system includes one or more processors, such as a processor for managing monoblocs. The processor is connected to a communication infrastructure (e.g., a communications bus, cross over bar, or network). Various software embodiments are described in terms of this computer system. After reading this description, it will become apparent to a person skilled in the relevant art(s) how to implement various embodiments using other computer systems and/or architectures. A computer system can include a display interface that forwards graphics, text, and other data from the communication infrastructure (or from a frame buffer not shown) for display on a display unit.

A computer system also includes a main memory, such as for example random access memory (RAM), and may also include a secondary memory or in-memory (non-spinning) hard drives. The secondary memory may include, for example, a hard disk drive and/or a removable storage drive, representing a disk drive, a magnetic tape drive, an optical disk drive, etc. The removable storage drive reads from and/or writes to a removable storage unit in a well-known manner. Removable storage unit represents a disk, magnetic tape, optical disk, solid state memory, etc. which is read by and written to by removable storage drive. As will be appreciated, the removable storage unit includes a computer usable storage medium having stored therein computer software and/or data.

In various embodiments, secondary memory may include other similar devices for allowing computer programs or other instructions to be loaded into computer system. Such devices may include, for example, a removable storage unit and an interface. Examples of such may include a program cartridge and cartridge interface (such as that found in video game devices), a removable memory chip (such as an erasable programmable read only memory (EPROM), or programmable read only memory (PROM)) and associated socket, and other removable storage units and interfaces, which allow software and data to be transferred from the removable storage unit to a computer system.

A computer system may also include a communications interface. A communications interface allows software and data to be transferred between computer system and external devices. Examples of communications interface may include a modem, a network interface (such as an Ethernet card), a communications port, a Personal Computer Memory Card International Association (PCMCIA) slot and card, etc. Software and data transferred via communications interface are in the form of signals which may be electronic, electromagnetic, optical or other signals capable of being received by a communications interface. These signals are provided to communications interface via a communications path (e.g., channel). This channel carries signals and may be implemented using wire, cable, fiber optics, a telephone line, a cellular link, a radio frequency (RF) link, wireless and other communications channels.

The terms "computer program medium" and "computer usable medium" and "computer readable medium" are used to generally refer to media such as removable storage drive and a hard disk. These computer program products provide software to a computer system.

Computer programs (also referred to as computer control logic) are stored in main memory and/or secondary memory. Computer programs may also be received via a communications interface. Such computer programs, when executed, enable the computer system to perform certain features as discussed herein. In particular, the computer programs, when executed, enable the processor to perform certain features of various embodiments. Accordingly, such computer programs represent controllers of the computer system.

In various embodiments, software may be stored in a computer program product and loaded into computer system using removable storage drive, hard disk drive or communications interface. The control logic (software), when executed by the processor, causes the processor to perform the functions of various embodiments as described herein. In various embodiments, hardware components such as application specific integrated circuits (ASICs) may be utilized in place of software-based control logic. Implementation of a hardware state machine so as to perform the functions described herein will be apparent to persons skilled in the relevant art(s).

A web client includes any device (e.g., a personal computer) which communicates via any network, for example such as those discussed herein. Such browser applications comprise Internet browsing software installed within a computing unit or a system to conduct online transactions and/or communications. These computing units or systems may take the form of a computer or set of computers, although other types of computing units or systems may be used, including laptops, notebooks, tablets, hand held computers, personal digital assistants, set-top boxes, workstations, computer-servers, main frame computers, mini-computers, PC servers, pervasive computers, network sets of computers, personal computers, kiosks, terminals, point of sale (POS) devices and/or terminals, televisions, or any other device capable of receiving data over a network. A web-client may run Internet Explorer or Edge offered by Microsoft Corporation, Chrome offered by Google, Safari offered by Apple Computer, or any other of the myriad software packages available for accessing the Internet.

Practitioners will appreciate that a web client may or may not be in direct contact with an application server. For example, a web client may access the services of an application server through another server and/or hardware component, which may have a direct or indirect connection to an Internet server. For example, a web client may communicate with an application server via a load balancer. In various embodiments, access is through a network or the Internet through a commercially-available web-browser software package.

A web client may implement security protocols such as Secure Sockets Layer (SSL) and Transport Layer Security (TLS). A web client may implement several application layer protocols including http, https, ftp, and sftp. Moreover, in various embodiments, components, modules, and/or engines of an example system may be implemented as micro-applications or micro-apps. Micro-apps are typically deployed in the context of a mobile operating system, including for example, iOS offered by Apple Computer, Android offered by Google, Windows Mobile offered by Microsoft Corporation, and the like. The micro-app may be configured to leverage the resources of the larger operating system and associated hardware via a set of predetermined rules which govern the operations of various operating systems and hardware resources. For example, where a micro-app desires to communicate with a device or network other than the mobile device or mobile operating system, the micro-app may leverage the communication protocol of the operating system and associated device hardware under the predetermined rules of the mobile operating system. Moreover, where the micro-app desires an input from a user, the micro-app may be configured to request a response from the operating system which monitors various hardware components and then communicates a detected input from the hardware to the micro-app.

As used herein an "identifier" may be any suitable identifier that uniquely identifies an item, for example a battery 100. For example, the identifier may be a globally unique identifier.

As used herein, the term "network" includes any cloud, cloud computing system or electronic communications system or method which incorporates hardware and/or software components. Communication among the parties may be accomplished through any suitable communication channels, such as, for example, a telephone network, an extranet, an intranet, Internet, point of interaction device (point of sale device, smartphone, cellular phone, kiosk, etc.), online communications, satellite communications, off-line communications, wireless communications, transponder communications, local area network (LAN), wide area network (WAN), virtual private network (VPN), networked or linked devices, keyboard, mouse and/or any suitable communication or data input modality. Moreover, although the system is frequently described herein as being implemented with TCP/IP communications protocols, the system may also be implemented using IPX, APPLE^{®}talk, IP-6, NetBIOS^{®}, OSI, any tunneling protocol (e.g. IPsec, SSH), or any number of existing or future protocols. If the network is in the nature of a public network, such as the Internet, it may be advantageous to presume the network to be insecure and open to eavesdroppers. Specific information related to the protocols, standards, and application software utilized in connection with the Internet is generally known to those skilled in the art and, as such, need not be detailed herein. See, for example, Dilip Naik, Internet Standards and Protocols (1998); JAVA^{®} 2 Complete, various authors, (Sybex 1999); Deborah Ray and Eric Ray, Mastering HTML 4.0 (1997); and Loshin, TCP/IP Clearly Explained (1997) and David Gourley and Brian Totty, HTTP, The Definitive Guide (2002). The various system components may be independently, separately or collectively suitably coupled to the network via data links.

"Cloud" or "cloud computing" includes a model for enabling convenient, on-demand network access to a shared pool of configurable computing resources (e.g., networks, servers, storage, applications, and services) that can be rapidly provisioned and released with minimal management effort or service provider interaction. Cloud computing may include location-independent computing, whereby shared servers provide resources, software, and data to computers and other devices on demand. For more information regarding cloud computing, see the NIST's (National Institute of Standards and Technology) definition of cloud computing available at https://doi.org/10.6028/NIST.SP.800-145 (last visited July 2018).

As used herein, "transmit" may include sending electronic data from one system component to another over a network connection. Additionally, as used herein, "data" may include encompassing information such as commands, queries, files, data for storage, and the like in digital or any other form.

The system contemplates uses in association with web services, utility computing, pervasive and individualized computing, security and identity solutions, autonomic computing, cloud computing, commodity computing, mobility and wireless solutions, open source, biometrics, grid computing and/or mesh computing.

Any databases discussed herein may include relational, hierarchical, graphical, blockchain, object-oriented structure and/or any other database configurations. Common database products that may be used to implement the databases include DB2 by IBM^{®} (Armonk, NY), various database products available from ORACLE^{®} Corporation (Redwood Shores, CA), MICROSOFT^{®} Access^{®} or MICROSOFT^{®} SQL Server^{®} by MICROSOFT^{®} Corporation (Redmond, Washington), MySQL by MySQL AB (Uppsala, Sweden), MongoDB^{®}, Redis^{®}, Apache Cassandra^{®}, HBase by APACHE^{®}, MapR-DB, or any other suitable database product. Moreover, the databases may be organized in any suitable manner, for example, as data tables or lookup tables. Each record may be a single file, a series of files, a linked series of data fields or any other data structure.

Any database discussed herein may comprise a distributed ledger maintained by a plurality of computing devices (e.g., nodes) over a peer-to-peer network. Each computing device maintains a copy and/or partial copy of the distributed ledger and communicates with one or more other computing devices in the network to validate and write data to the distributed ledger. The distributed ledger may use features and functionality of blockchain technology, including, for example, consensus based validation, immutability, and cryptographically chained blocks of data. The blockchain may comprise a ledger of interconnected blocks containing data. The blockchain may provide enhanced security because each block may hold individual transactions and the results of any blockchain executables. Each block may link to the previous block and may include a timestamp. Blocks may be linked because each block may include the hash of the prior block in the blockchain. The linked blocks form a chain, with only one successor block allowed to link to one other predecessor block for a single chain. Forks may be possible where divergent chains are established from a previously uniform blockchain, though typically only one of the divergent chains will be maintained as the consensus chain. In various embodiments, the blockchain may implement smart contracts that enforce data workflows in a decentralized manner. The system may also include applications deployed on user devices such as, for example, computers, tablets, smartphones, Internet of Things devices ("IoT" devices), etc. The applications may communicate with the blockchain (e.g., directly or via a blockchain node) to transmit and retrieve data. In various embodiments, a governing organization or consortium may control access to data stored on the blockchain. Registration with the managing organization(s) may enable participation in the blockchain network.

Data transfers performed through the blockchain-based system may propagate to the connected peers within the blockchain network within a duration that may be determined by the block creation time of the specific blockchain technology implemented. The system also offers increased security at least partially due to the relative immutable nature of data that is stored in the blockchain, reducing the probability of tampering with various data inputs and outputs. Moreover, the system may also offer increased security of data by performing cryptographic processes on the data prior to storing the data on the blockchain. Therefore, by transmitting, storing, and accessing data using the system described herein, the security of the data is improved, which decreases the risk of the computer or network from being compromised.

In various embodiments, the system may also reduce database synchronization errors by providing a common data structure, thus at least partially improving the integrity of stored data. The system also offers increased reliability and fault tolerance over traditional databases (e.g., relational databases, distributed databases, etc.) as each node operates with a full copy of the stored data, thus at least partially reducing downtime due to localized network outages and hardware failures. The system may also increase the reliability of data transfers in a network environment having reliable and unreliable peers, as each node broadcasts messages to all connected peers, and, as each block comprises a link to a previous block, a node may quickly detect a missing block and propagate a request for the missing block to the other nodes in the blockchain network.

### Exemplary Configurations of Monoblocs

In addition to FIG. 1 and FIG. 2, FIGS. 5-9 depict other exemplary embodiments of a monobloc 100, including the housing 110 and constituents of the housing, and the battery monitor circuit 120. Exemplary monoblocs designs include sealed designs, absorbed glass mat designs, non-absorbed glass mat designs both gel or vented.

### Housing

The housing or case 110 of the monobloc 100 comprises a top case component 111 and a primary case component 112 that when assembled, define at least one cell within the monobloc case. The primary case component 112 further comprises integral sides 117, a bottom (not shown) and a bottom sealing surface (116) that corresponds to the uppermost surfaces of the integral sides. In one embodiment, the primary case component has a draft (not shown) directed toward the bottom such the integral sides slope inward from their uppermost surfaces to the bottom. Additionally, the primary case component may further comprise at least one integral interior wall (not shown) such that the primary case component and the top case component, when assembled, define a number of cells (not shown) in the monobloc case equal to the number of interior wall(s) plus one.

### Top Case Component

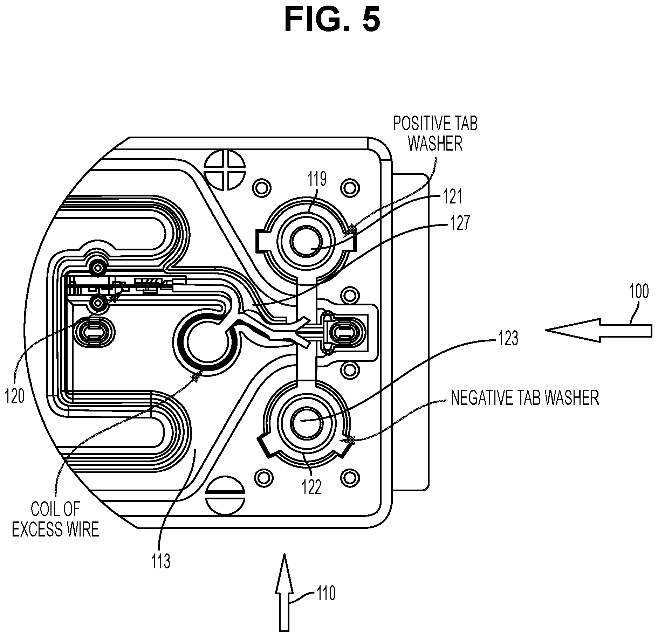

Referring to FIGS. 5-9, the top case component 111 comprises a top exterior surface 113, a top interior surface 114, a top sealing surface 115 configured to be sealingly bonded with a bottom sealing surface 116 of a primary case component 112 of the monobloc case 110. The top case component further comprises a positive terminal opening 119 configured for a positive terminal pole 121 of a monobloc to protrude through a negative terminal opening 122 configured for a negative terminal pole 123 of the monobloc to protrude through.

### Pocket

The top exterior surface 113 of the monobloc case 110 comprises a pocket 124 configured to house a battery monitor circuit 120 (shown in the figures on a single circuit board), wherein at least a bottommost surface of the pocket 125 is below the top sealing surface 115 such that when the top case component 111 is bonded to the primary case component 112 the pocket 125 extends into the interior of the monobloc case past the sealed interface of the top case component and the primary case component. Advantageously, because the pocket extends into the interior of the monobloc case, a temperature sensor placed within the pocket is closer to one or more electrochemical cell pack(s) within an assembled monobloc and able to more accurately determine the temperature at one or more locations therein. In one embodiment, the pocket may be positioned in the top case component so that the pocket will be proximate to an intercell connector (not shown) between electrochemical cell packs (not shown) of the monobloc, which tends to result in a more accurate determination of the temperature within the monobloc.

The pocket may be configured to house the battery monitor circuit 120 at an orientation selected from the group consisting of substantially horizontal (FIG. 6 and FIG. 7), substantially vertical (FIG. 5, FIG. 8, and FIG. 9) or between substantially vertical and substantially horizontal (not shown). Further, the pocket may be configured to comprise one or more structures 126 for aligning and/or securing the battery monitor circuit within the pocket such as grooves, standoff pads, tabs, etc. and combinations thereof.

### Pathway

Further, the top exterior surface 113 comprises at least one pathway 127 configured to house electrically conducting positive and negative connections 128, 129, respectively, that place the monobloc parameter monitoring device and the wireless communications device in electrical connection with the positive and negative terminal poles 121, 123 of the monobloc 100.

### Battery Monitor Circuit

It is to be noted that the various components disclosed above as comprised by the battery monitor circuit 120 (e.g., the voltage sensor 130, the temperature sensor 140, the processor 150, the transceiver 160, the antenna 170, and the storage medium (not shown)), need not be part of a single circuit board. These components may reside on multiple circuit boards, may be free standing, or part of a different arrangement. The battery monitor circuit comprises:
a voltage sensor configured to be electrically connected to the positive and negative terminal poles of the monobloc for receiving power from the monobloc and for monitoring a voltage between the positive and negative terminal poles of the monobloc;
a temperature sensor for monitoring a temperature at a location within the lead-acid monobloc that is below the top sealing surface of the lead-acid monobloc;
a processor for receiving a monitored voltage signal from the voltage sensor, for receiving a monitored temperature signal from the temperature sensor, for processing the monitored voltage signal and the monitored temperature signal, and for generating voltage data and temperature data based on the monitored voltage signal and the monitored temperature signal;
a memory for storing the voltage data and the temperature data, wherein the voltage data represents the voltage between the positive and negative terminal poles of the monobloc, and wherein the temperature data represents a temperature of the monobloc;
an antenna; and
a transceiver for wirelessly communicating the voltage data and the temperature data to a remote device via the antenna.

Further, in an exemplary embodiment these components may be categorized as or part of two distinct devices: a monobloc parameter monitoring device and a wireless communications device; that may be include on a single circuit board or on separate circuit boards. Wherein the monobloc parameter monitoring device comprises:
a voltage sensor configured to be electrically connected to the positive and negative terminal poles of the monobloc for receiving power from the monobloc and for monitoring a voltage between the positive and negative terminal poles of the monobloc;
a temperature sensor for monitoring a temperature at a location within the lead-acid monobloc that is below the top sealing surface of the lead-acid monobloc; and
a processor for receiving a monitored voltage signal from the voltage sensor, for receiving a monitored temperature signal from the temperature sensor, for processing the monitored voltage signal and the monitored temperature signal, and for generating voltage data and temperature data based on the monitored voltage signal and the monitored temperature signal; a memory for storing the voltage data and the temperature data, wherein the voltage data represents the voltage between the positive and negative terminal poles of the monobloc, and wherein the temperature data represents a temperature of the monobloc.
Wherein the wireless communications device comprises:
an antenna; and
a transceiver for wirelessly communicating the voltage data and the temperature data to a remote device via the antenna.

### Securing and Protecting the Electronics

The top case component may also comprise a composition for securing and protecting the battery monitor circuit (or monobloc parameter monitoring device and the wireless communications device) housed in the pocket and the electrically conducting connections housed in the at least one pathway. In an embodiment, the composition is selected from the group consisting of potting material, adhesive, and combinations thereof. Exemplary compositions include ITW Plexus^{™} MA350 Methacrylate Adhesive, ITW Plexus^{™} MA300 Methacrylate Adhesive, Kalex^{™} 15036 A/B Epoxy, Kalex^{™} 14536 Urethane Potting Material, Kalex^{™} 16552 Polyurethane Potting Material, EPOCAP^{™} 19174 Epoxy, EPOCAP^{™} 25137 Epoxy, and Huntsman Aradur^{™} 8763 Epoxy.

### Wireless Enabled Monobloc or WEM

The monobloc case, including the above-described top case component, when assembled to make a monobloc, the monobloc is considered to be a wireless enabled monobloc or WEM, an example of which is the ACE ENABLED^{™} monobloc available from NorthStar Battery Company. More specifically, the wireless enabled lead-acid monobloc comprises: the above-described monobloc case; an electrochemical cell pack in each cell; an intercell connector between each electrochemical cell pack; the positive and negative terminal poles in electrical connection with the electrochemical cell pack(s); and the battery monitor circuit (or monobloc parameter monitoring device and the wireless communications device) is/are in electrical connection with the positive and negative terminal poles.

### Battery Pack

In another embodiment, the invention is directed to a battery pack comprising: at least one string of wireless enabled monoblocs, wherein each string comprises a plurality of the above-described wireless enabled lead-acid monoblocs electrically connected in series or parallel; and battery pack positive and negative terminals electrically connected to the string or strings, wherein the strings are electrically connected in parallel.

Principles of the present disclosure may be combined with and/or utilized in connection with principles disclosed in other applications. For example, principles of the present disclosure may be combined with principles disclosed in: U.S. Prov. Pat. App. No. 62/538,622, entitled ENERGY STORAGE DEVICE, SYSTEMS AND METHODS FOR MONITORING AND PERFORMING DIAGNOSTICS ON POWER DOMAINS, filed July 28, 2017; U.S. Prov. Pat. App. No. 62/599,958, entitled WIRELESS ENABLED MONOBLOC, filed December 18, 2017; U.S. Prov. Pat. App. No. 62/659,929, filed April 19, 2018, entitled *SYSTEMS AND METHODS FOR MONITORING BATTERY PERFORMANCE*; U.S. Prov. Pat. App. No. 62/660,157, filed April 19, 2018, entitled *SYSTEMS AND METHODS FOR ANALYSIS OF MONITORED TRANSPORTATION BATTERY DATA*; U.S. Prov. Pat. App. No. 62/679,648, filed June 1, 2018, entitled *DETERMINING THE STATE OF CHARGE OF A DISCONNECTED BATTERY*; U.S. Serial No. 16/046,727, filed July 26, 2018, entitled *ENERGY STORAGE DEVICE, SYSTEMS AND METHODS FOR MONITORING AND PERFORMING DIAGNOSTICS ON BATTERIES*; U.S. Serial No. 16/046,883, filed July 26, 2018, entitled *SYSTEMS AND METHODS FOR DETERMINING A STATE OF CHARGE OF A DISCONNECTED BATTERY*; U.S. Serial No. 16/046,671, filed July 26, 2018, entitled *SYSTEMS AND METHODS FOR UTILIZING BATTERY OPERATING DATA*; U.S. Serial No. 16/046,709, filed July 26, 2018, entitled *SYSTEMS AND METHODS FOR UTILIZING BATTERY OPERATING DATA AND EXOGENOUS DATA*; U.S. Serial No. 16/046,747, filed July 26, 2018, entitled *SYSTEMS AND METHODS FOR DETERMINING CRANK HEALTH OF A BATTERY*; U.S. Serial No. 16/046,855, filed July 26, 2018, entitled *OPERATING CONDITIONS INFORMATION SYSTEM FOR AN ENERGY STORAGE DEVICE;* U.S. Serial No. 16/046,774, filed on July 26, 2018, entitled *SYSTEMS AND METHODS FOR DETERMINING A RESERVE TIME OF A MONOBLOC*; U.S. Serial No. 16/046,687, filed July 26, 2018, entitled *SYSTEMS AND METHODS FOR DETERMINING AN OPERATING MODE OF A BATTERY*; U.S. Serial No. 16/046,811, filed July 26, 2018, entitled *SYSTEMS AND METHODS FOR DETERMINING A STATE OF CHARGE OF A BATTERY*; U.S. Serial No. 16/046,792, filed July 26, 2018, entitled *SYSTEMS AND METHODS FOR MONITORING AND PRESENTING BATTERY INFORMATION*; U.S. Serial No. 16/046,737, filed July 26, 2018, entitled *SYSTEMS AND METHODS FOR DETERMINING A HEALTH STATUS OF A MONOBLOC*; U.S. Serial No. 16/046,773, filed July 26, 2018, entitled *SYSTEMS AND METHODS FOR DETECTING BATTERY THEFT*; U.S. Serial No. 16/046,791, filed on July 26, 2018, entitled *SYSTEMS AND METHODS FOR DETECTING THERMAL RUNAWAY OF A BATTERY*; and U.S. Serial No. 16/046,777, filed July 26, 2018, entitled *BATTERY WITH INTERNAL MONITORING SYSTEM.*

In describing the present disclosure, the following terminology will be used: The singular forms "a," "an," and "the" include plural referents unless the context clearly dictates otherwise. Thus, for example, reference to an item includes reference to one or more items. The term "ones" refers to one, two, or more, and generally applies to the selection of some or all of a quantity. The term "plurality" refers to two or more of an item. The term "about" means quantities, dimensions, sizes, formulations, parameters, shapes and other characteristics need not be exact, but may be approximated and/or larger or smaller, as desired, reflecting acceptable tolerances, conversion factors, rounding off, measurement error and the like and other factors known to those of skill in the art. The term "substantially" means that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide. Numerical data may be expressed or presented herein in a range format. It is to be understood that such a range format is used merely for convenience and brevity and thus should be interpreted flexibly to include not only the numerical values explicitly recited as the limits of the range, but also interpreted to include all of the individual numerical values or sub-ranges encompassed within that range as if each numerical value and sub-range is explicitly recited. As an illustration, a numerical range of "about 1 to 5" should be interpreted to include not only the explicitly recited values of about 1 to about 5, but also include individual values and sub-ranges within the indicated range. Thus, included in this numerical range are individual values such as 2, 3 and 4 and sub-ranges such as 1-3, 2-4 and 3-5, etc. This same principle applies to ranges reciting only one numerical value (e.g., "greater than about 1") and should apply regardless of the breadth of the range or the characteristics being described. A plurality of items may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. Furthermore, where the terms "and" and "or" are used in conjunction with a list of items, they are to be interpreted broadly, in that any one or more of the listed items may be used alone or in combination with other listed items. The term "alternatively" refers to selection of one of two or more alternatives, and is not intended to limit the selection to only those listed alternatives or to only one of the listed alternatives at a time, unless the context clearly indicates otherwise.

It should be appreciated that the particular implementations shown and described herein are illustrative and are not intended to otherwise limit the scope of the present disclosure in any way. Furthermore, the connecting lines shown in the various figures contained herein are intended to represent exemplary functional relationships and/or physical couplings between the various elements. It should be noted that many alternative or additional functional relationships or physical connections may be present in a practical device or system.

Moreover, where a phrase similar to 'at least one of A, B, and C' or 'at least one of A, B, or C' is used in the claims or specification, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C.

Having illustrated and described the principles of the present invention, it should be apparent to persons skilled in the art that the invention can be modified in arrangement and detail without departing from such principles.

## Claims

1. A top case component of a lead-acid monobloc case, the top case component comprising:
a top exterior surface of the monobloc case;
a top interior surface of the monobloc case;
a top sealing surface configured to be sealingly bonded with a bottom sealing surface of a primary case component of the monobloc case, wherein the primary case component further comprises integral sides and bottom and the bottom sealing surface corresponds to the uppermost surfaces of the integral sides;
a positive terminal opening configured for a positive terminal pole of a monobloc to protrude through; and
a negative terminal opening configured for a negative terminal pole of the monobloc to protrude through;
wherein the top exterior surface of the monobloc case comprises:
a pocket configured to house a battery monitor circuit, wherein at least a bottommost surface of the pocket is below the top sealing surface such that when the top case component is bonded to the primary case component the pocket extends into an interior of the monobloc case past the sealed interface of the top case component and the primary case component; and
at least one pathway configured to house electrically conducting connections that place the battery monitor circuit in electrical connection with the positive and negative terminal poles of the monobloc.

2. The top case component of claim 1, wherein the pocket is configured in the top case component so that the pocket will be proximate to an intercell connector between electrochemical cell packs of the monobloc.

3. The top case component of claim 1 or claim 2, wherein the battery monitor circuit is on a circuit board,
wherein the pocket is configured to house the circuit board at an orientation selected from the group consisting of substantially horizontal, substantially vertical, or between substantially vertical and substantially horizontal, and
wherein the pocket comprises one or more structures configured to secure the circuit board within the pocket.

4. The top case component of any one of claims 1-3, further comprising:
the battery monitor circuit housed in the pocket; and
the electrically conducting connections housed in the at least one pathway.

5. The top case component of any one of claims 1-4, wherein the battery monitor circuit comprises:
a voltage sensor configured to be electrically connected to the positive and negative terminal poles of the monobloc for receiving power from the monobloc and for monitoring a voltage between the positive and negative terminal poles of the monobloc;
a temperature sensor for monitoring a temperature at a location within the lead-acid monobloc that is below the top sealing surface of the lead-acid monobloc;
a processor for receiving a monitored voltage signal from the voltage sensor, for receiving a monitored temperature signal from the temperature sensor, for processing the monitored voltage signal and the monitored temperature signal, and for generating voltage data and temperature data based on the monitored voltage signal and the monitored temperature signal;
a memory for storing the voltage data and the temperature data, wherein the voltage data represents the voltage between the positive and negative terminal poles of the monobloc, and wherein the temperature data represents a temperature of the monobloc;
an antenna; and
a transceiver for wirelessly communicating the voltage data and the temperature data to a remote device via the antenna.

6. The top case component of claim 5, wherein the battery monitor circuit further comprises a geo-location device for identifying a location of the top case component, and representing the location of the top case component with location data.

7. The top case component of claim 5 or claim 6, further comprising a composition for securing and protecting the battery monitor circuit housed in the pocket and the electrically conducting connections housed in the at least one pathway.

8. The top case component of any of claims 5-7, wherein the processor is configured to analyze the voltage data and the temperature data and generate information derived from the voltage data and the temperature data.

9. The top case component of any of claims 5-8, wherein the memory contains operating history of the monobloc in a battery operating history matrix, and wherein the battery operating history matrix comprises:
a plurality of columns, each column representing a voltage range of the monobloc; and
a plurality of rows, each row representing a temperature range of the monobloc, wherein a numerical value in a cell of the battery operating history matrix represents a cumulative amount of time that the monobloc has been in a particular state corresponding to the voltage range and the temperature range for that cell.

10. The top case component of claim 9, wherein, during operation of the battery monitor circuit, the memory stores information corresponding to the cumulative amount of time that the monobloc is in each of the plurality of states represented by the battery operating history matrix over a time period for which the battery monitor circuit is electrically connected to the monobloc, thereby characterizing the entire connected life of the monobloc, without increasing the storage space in the memory occupied by the battery operating history matrix.

11. The top case component of claim 10, wherein the remote device further comprises a remote display system, remote from the monobloc, for displaying a location history and a battery operation history of the monobloc.

12. A lead-acid monobloc case, the case comprising the primary case component and the top case component of any one of claims 1-11, wherein the primary case component and the top case component, when assembled, define at least one cell within the monobloc case.

13. The lead-acid monobloc case of claim 12, wherein the primary case component has a draft directed toward the bottom such the integral sides slope inward from their uppermost surfaces to the bottom, and
wherein the primary case component further comprises at least one integral interior wall such that the primary case component and the top case component, when assembled, define a number of cells in the monobloc case.

14. A wireless enabled lead-acid monobloc comprising:
the lead-acid monobloc case of claim 12 or claim 13;
an electrochemical cell pack in each cell;
an intercell connector between each electrochemical cell pack;
the positive and negative terminal poles in electrical connection with the electrochemical cell pack(s); and
the monobloc parameter monitoring device and the wireless communications device are in electrical connection with the positive and negative terminal poles.

15. A battery pack comprising:
at least one string of wireless enabled monoblocs, wherein each string comprises a plurality of the wireless enabled lead-acid monoblocs of claim 14 electrically connected in series or parallel; and
battery pack positive and negative terminals electrically connected to the string or strings, wherein the strings are electrically connected in parallel.

## Patentansprüche

1. Oberer Gehäuseteil eines Blei-Säure-Monoblock-Gehäuses, wobei der obere Gehäuseteil umfasst:
eine obere Außenfläche des Monoblock-Gehäuses;
eine obere Innenfläche des Monoblock-Gehäuses;
eine obere Dichtungsfläche, die konfiguriert ist, um mit einer unteren Dichtungsfläche eines Hauptgehäuseteils des Monoblock-Gehäuses abdichtend verbunden zu sein, wobei der Hauptgehäuseteil ferner integrale Seiten und einen Boden umfasst und die untere Dichtungsfläche den obersten Flächen der integralen Seiten entspricht;
eine Pluspol-Öffnung, die so konfiguriert ist, dass daraus ein Pluspol eines Monoblocks hervorstehen kann; und
eine Minuspol-Öffnung, die so konfiguriert ist, dass daraus ein Minuspol des Monoblocks hervorstehen kann;
wobei die obere Außenfläche des Monoblock-Gehäuses umfasst:
eine Aussparung, die konfiguriert ist, um eine Batterieüberwachungsschaltung aufzunehmen, wobei wenigstens eine unterste Fläche der Aussparung sich unter der oberen Dichtungsfläche befindet, so dass wenn der obere Gehäuseteil mit dem Hauptgehäuseteil verbunden ist, die Aussparung sich in ein Inneres des Monoblock-Gehäuses über die abgedichtete Grenzfläche zwischen dem oberen Gehäuseteil und dem Hauptgehäuseteil erstreckt; und
wenigstens eine Leitungsbahn, die konfiguriert ist, um elektrisch leitende Verbindungen, die die Batterieüberwachungsschaltung in elektrische Verbindung mit den Plus- und Minuspolen des Monoblocks bringen, aufzunehmen.

2. Oberer Gehäuseteil nach Anspruch 1, wobei die Aussparung in dem oberen Gehäuseteil so konfiguriert ist, dass die Aussparung sich in der Nähe eines Zellenverbinders zwischen elektrochemischen Zellenpacks des Monoblocks befinden werden.

3. Oberer Gehäuseteil nach Anspruch 1 oder Anspruch 2, wobei die Batterieüberwachungsschaltung sich an einer Leiterplatte befindet,
wobei die Aussparung konfiguriert ist, um die Leiterplatte in einer Ausrichtung, ausgewählt aus der Gruppe bestehend aus im Wesentlichen horizontal, im Wesentlichen vertikal oder zwischen im Wesentlichen vertikal und im Wesentlichen horizontal, aufzunehmen, und
wobei die Aussparung eine oder mehrere Strukturen umfasst, die konfiguriert ist/sind, um die Leiterplatte in der Aussparung zu befestigen.

4. Oberer Gehäuseteil nach einem der Ansprüche 1-3, ferner umfassend:
die in der Aussparung untergebrachte Batterieüberwachungsschaltung und
die in der wenigstens einen Leitungsbahn untergebrachten elektrisch leitenden Verbindungen.

5. Oberer Gehäuseteil nach einem der Ansprüche 1-4, wobei die Batterieüberwachungsschaltung umfasst:
einen Spannungssensor, der konfiguriert ist, um mit den Plus- und Minuspolen des Monoblocks elektrisch verbunden zu sein, so dass er Strom vom Monoblock erhält und eine Spannung zwischen den Plus- und Minuspolen des Monoblocks überwacht;
einen Temperatursensor zur Überwachung einer Temperatur an einem Ort innerhalb des Blei-Säure-Monoblocks, der sich unterhalb der oberen Dichtungsfläche des Blei-Säure-Monoblocks befindet;
einen Prozessor zum Empfang eines Signals der überwachten Spannung vom Spannungssensor, zum Empfang eines Signals der überwachten Temperatur vom Temperatursensor, zum Verarbeiten des Signals der überwachten Spannung und des Signals der überwachten Temperatur, und zum Erzeugen von Spannungsdaten und Temperaturdaten basierend auf dem Signal der überwachten Spannung und dem Signal der überwachten Temperatur;
einen Speicher zum Speichern der Spannungsdaten und der Temperaturdaten, wobei die Spannungsdaten die Spannung zwischen den Plus- und Minuspolen des Monoblocks wiedergeben und wobei die Temperaturdaten eine Temperatur des Monoblocks wiedergeben;
eine Antenne; und
einen Transceiver zur drahtlosen Kommunikation der Spannungsdaten und der Temperaturdaten an ein entferntes Gerät über die Antenne.

6. Oberer Gehäuseteil nach Anspruch 5, wobei die Batterieüberwachungsschaltung ferner ein Geo-Positionsgerät umfasst zur Identifizierung einer Position des oberen Gehäuseteils und zur Wiedergabe der Position des oberen Gehäuseteils durch Positionsdaten.

7. Oberer Gehäuseteil nach Anspruch 5 oder Anspruch 6, ferner umfassend eine Zusammensetzung zum Befestigen und Schützen der in der Aussparung untergebrachten Batterieüberwachungsschaltung und der in der wenigstens einen Leitungsbahn untergebrachten elektrisch leitenden Verbindungen.

8. Oberer Gehäuseteil nach einem der Ansprüche 5-7, wobei der Prozessor konfiguriert ist, um die Spannungsdaten und die Temperaturdaten zu analysieren und aus den Spannungsdaten und den Temperaturdaten abgeleitete Informationen zu erzeugen.

9. Oberer Gehäuseteil nach einem der Ansprüche 5-8, wobei der Speicher eine Betriebshistorie des Monoblocks in einer Batteriebetriebshistorienmatrix enthält, und wobei die Batteriebetriebshistorienmatrix umfasst:
eine Mehrzahl von Spalten, wobei jede Spalte einen Spannungsbereich des Monoblocks wiedergibt; und
eine Mehrzahl von Reihen, wobei jede Reihe einen Temperaturbereich des Monoblocks wiedergibt, wobei ein numerischer Wert in einer Zelle der Batteriebetriebshistorienmatrix eine kumulative Menge der Zeit wiedergibt, in der sich der Monoblock in einem bestimmten Zustand befunden hat, welcher dem Spannungsbereich und dem Temperaturbereich für diese Zelle entspricht.

10. Oberer Gehäuseteil nach Anspruch 9, wobei während des Betriebs der Batterieüberwachungsschaltung der Speicher Informationen speichert, die der kumulativen Menge der Zeit entsprechen, in der der Monoblock sich in jedem der mehreren Zustände befindet, die durch die Batteriebetriebshistorienmatrix wiedergegeben wird, über einen Zeitraum, in dem die Batterieüberwachungsschaltung mit dem Monoblock elektrisch verbunden ist, so dass dadurch die gesamte Verbindungsdauer des Monoblocks beschrieben wird, ohne dass der Speicherplatz im Speicher, der von der Batteriebetriebshistorienmatrix belegt wird, erhöht wird.

11. Oberer Gehäuseteil nach Anspruch 10, wobei das entfernte Gerät ferner ein Fernanzeigesystem, entfernt vom Monoblock, umfasst, zur Anzeige einer Positionshistorie und einer Batteriebetriebshistorie des Monoblocks.

12. Blei-Säure-Monoblock-Gehäuse, wobei das Gehäuse den Hauptgehäuseteil und den oberen Gehäuseteil nach einem der Ansprüche 1-11 umfasst, wobei der Hauptgehäuseteil und der obere Gehäuseteil, wenn sie zusammengefügt sind, wenigstens eine Zelle innerhalb des Monoblock-Gehäuses definieren.

13. Blei-Säure-Monoblock-Gehäuse nach Anspruch 12, wobei der Hauptgehäuseteil eine zum Boden gerichtete Schräge aufweist, so dass sich die integralen Seiten von ihren obersten Flächen zum Boden hin nach innen neigen, und
wobei der Hauptgehäuseteil ferner wenigstens eine integrale Innenwand umfasst, so dass der Hauptgehäuseteil und der obere Gehäuseteil, wenn sie zusammengefügt sind, eine Reihe von Zellen im Monoblock-Gehäuse definieren.

14. Drahtlosfähiger Blei-Säure-Monoblock, umfassend:
das Blei-Säure-Monoblock-Gehäuse nach Anspruch 12 oder Anspruch 13;
ein elektrochemisches Zellenpack in jeder Zelle;
einen Zellenverbinder zwischen jedem elektrochemischen Zellenpack;
die Plus- und Minuspole in elektrischer Verbindung mit dem/den elektrochemischen Zellenpack(s); und
wobei das Monoblockparameterüberwachungsgerät und das Drahtloskommunikationsgerät in elektrischer Verbindung mit den Plus- und Minuspolen stehen.

15. Batteriepack, umfassend:
wenigstens einen Kette von drahtlosfähigen Monoblöcken, wobei jede Kette eine Mehrzahl der drahtlosfähigen Blei-Säure-Monoblöcke nach Anspruch 14, elektrisch in Reihe oder parallel geschaltet, umfasst; und
Batteriepack-Plus- und -Minuspole, die elektrisch mit der/den Kette(n) verbunden sind, wobei die Ketten elektrochemisch parallel geschaltet sind.

## Revendications

1. Composant de boîtier supérieur d'un boîtier monobloc plomb-acide, le composant du boîtier supérieur comprenant :
une surface extérieure supérieure du boîtier monobloc ;
une surface intérieure supérieure du boîtier monobloc ;
une surface d'étanchéité supérieure configurée pour être collée de manière étanche à une surface d'étanchéité inférieure d'un composant primaire du boîtier monobloc, dans lequel le composant primaire du boîtier comprend en outre des côtés et un fond d'un seul tenant et la surface d'étanchéité inférieure correspond aux surfaces les plus élevées des côtés intégraux ;
une ouverture de borne positive configurée pour faire saillir un pôle de borne positive d'un monobloc ; et
une ouverture de borne négative configurée pour faire dépasser un pôle de la borne négative du monobloc ;
dans lequel la surface extérieure supérieure du boîtier monobloc comprend :
une poche configurée pour loger un circuit de surveillance de la batterie, dans lequel au moins une surface la plus inférieure de la poche est en dessous de la surface d'étanchéité supérieure de sorte que lorsque le composant du boîtier supérieur est collé au composant du boîtier primaire, la poche s'étend à l'intérieur du boîtier monobloc au-delà de l'interface scellée du composant du boîtier supérieur et du composant du boîtier primaire ; et
au moins une voie configurée pour abriter des connexions conductrices d'électricité qui placent le circuit de surveillance de la batterie en connexion électrique avec les pôles positifs et négatifs du monobloc.

2. Composant de boîtier supérieur selon la revendication 1, dans lequel la poche est configurée dans le composant du boîtier supérieur de manière à ce que la poche soit proche d'un connecteur intercellulaire entre les packs de cellules électrochimiques du monobloc.

3. Composant de boîtier supérieur selon la revendication 1 ou selon la revendication 2, dans lequel le circuit de surveillance de la batterie se trouve sur une carte à circuit imprimé,
dans lequel la poche est configurée pour loger la carte de circuit imprimé dans une orientation choisie dans le groupe constitué de sensiblement horizontale, sensiblement verticale, ou entre sensiblement verticale et sensiblement horizontale, et
dans lequel la poche comprend une ou plusieurs structures configurées pour fixer la carte de circuit imprimé dans la poche.

4. Composant de boîtier supérieur selon l'une quelconque des revendications 1 à 3, comprenant en outre : le circuit de surveillance de la batterie logé dans la poche ; et
les connexions conductrices d'électricité logées dans l'au moins une voie.

5. Composant de boîtier supérieur selon l'une quelconque des revendications 1 à 4, dans lequel le circuit de contrôle de la batterie comprend :
un capteur de tension configuré pour être connecté électriquement aux pôles de bornes positive et négative du monobloc pour recevoir une alimentation du monobloc et pour surveiller une tension entre les pôles de bornes positive et négative du monobloc ;
un capteur de température pour surveiller une température à un endroit dans le monobloc plomb-acide qui est en dessous de la surface d'étanchéité supérieure du monobloc plomb-acide ;
un processeur pour la réception d'un signal de tension surveillée provenant du capteur de tension, pour la réception d'un signal de température surveillée provenant du capteur de température, pour le traitement du signal de tension surveillée et du signal de température surveillée, et pour la génération de données de tension et de données de température sur la base du signal de tension surveillée et du signal de température surveillée ;
une mémoire pour stocker les données de tension et les données de température, dans lequel les données de tension représentent la tension entre les pôles de bornes positive et négative du monobloc, et dans lequel les données de température représentent une température du monobloc ;
une antenne ; et
un émetteur-récepteur pour la communication sans fil des données de tension et de température à un dispositif distant via l'antenne.

6. Composant de boîtier supérieur selon la revendication 5, dans lequel le circuit de surveillance de la batterie comprend en outre un dispositif de géolocalisation permettant d'identifier un emplacement du composant du boîtier supérieur et de représenter l'emplacement du composant du boîtier supérieur à l'aide de données de localisation.

7. Composant de boîtier supérieur selon la revendication 5 ou la revendication 6, comprenant en outre une composition pour sécuriser et protéger le circuit de surveillance de la batterie logé dans la poche et les connexions conductrices d'électricité logées dans au moins une voie.

8. Composant de boîtier supérieur selon l'une quelconque des revendications 5 à 7, dans lequel le processeur est configuré pour analyser les données de tension et les données de température et pour générer des informations dérivées des données de tension et des données de température.

9. Composant de boîtier supérieur selon l'une quelconque des revendications 5 à 8, dans lequel la mémoire contient l'historique de fonctionnement du monobloc dans une matrice d'historique de fonctionnement de la batterie, et dans lequel la matrice d'historique de fonctionnement de la batterie comprend :
une pluralité de colonnes, chaque colonne représentant une plage de tension du monobloc ; et
une pluralité de lignes, chaque ligne représentant une plage de température du monobloc, dans lequel une valeur numérique dans une cellule de la matrice de l'historique de fonctionnement de la batterie représente une durée cumulée pendant laquelle le monobloc a été dans un état particulier correspondant à la plage de tension et à la plage de température pour cette cellule.

10. Composant de boîtier supérieur selon la revendication 9, dans lequel, pendant le fonctionnement du circuit de surveillance de la batterie, la mémoire stocke des informations correspondant à la durée cumulée pendant laquelle le monobloc se trouve dans chacun de la pluralité d'états représentés par la matrice d'historique de fonctionnement de la batterie sur une période de temps pendant laquelle le circuit de surveillance de la batterie est électriquement connecté au monobloc, caractérisant ainsi l'ensemble de la vie connectée du monobloc, sans augmenter l'espace de stockage dans la mémoire occupé par la matrice d'historique de fonctionnement de la batterie.

11. Composant de boîtier supérieur selon la revendication 10, dans lequel le dispositif à distance comprend en outre un système d'affichage à distance, éloigné du monobloc, pour afficher un historique de localisation et un historique de fonctionnement de la batterie du monobloc.

12. Boîtier monobloc plomb-acide, comprenant le composant de boîtier primaire et le composant de boîtier supérieur selon l'une quelconque des revendications 1 à 11, dans lequel le composant de boîtier primaire et le composant de boîtier supérieur, une fois assemblés, définissent au moins une cellule à l'intérieur du boîtier monobloc.

13. Boîtier monobloc plomb-acide selon la revendication 12, dans lequel le composant de boîtier primaire présente une dépouille dirigée vers le fond, de sorte que les côtés intégraux s'inclinent vers l'intérieur à partir de leurs surfaces les plus élevées vers le fond, et
dans lequel le composant de boîtier primaire comprend en outre au moins une paroi intérieure intégrale de sorte que le composant de boîtier primaire et le composant de boîtier supérieur, une fois assemblés, définissent un certain nombre de cellules dans le boîtier monobloc.

14. Monobloc au plomb-acide activé sans fil comprenant :
le boîtier monobloc au plomb-acide selon la revendication 12 ou la revendication 13 ;
un bloc électrochimique dans chaque cellule ;
un connecteur intercellulaire entre chaque bloc de cellules électrochimiques ;
les pôles de bornes positive et négative en connexion électrique avec le(s) bloc(s) de cellules électrochimiques ; et
le dispositif de surveillance des paramètres du monobloc et le dispositif de communication sans fil sont reliés électriquement aux pôles de bornes positive et négative.

15. Bloc-batterie comprenant :
au moins une chaîne de monoblocs sans fil, dans lequel chaque chaîne comprend une pluralité de monoblocs au plomb-acide sans fil selon la revendication 14 connectés électriquement en série ou en parallèle ; et
les bornes positives et négatives du bloc batterie sont connectées électriquement à la ou aux chaînes, dans lequel les chaînes sont connectées électriquement en parallèle.
